## Europäisches Patentamt

## European Patent Office

## Office européen des brevets

(19)

(11) Veröffentlichungsnummer: **0 184 840**
**B1**

(12)

# EUROPÄISCHE PATENTSCHRIFT

(45) Veröffentlichungstag der Patentschrift:
24.05.89

(51) Int. Cl.⁴: **G01N 24/08**

(21) Anmeldenummer: 85115818.8

(22) Anmeldetag: **12.12.85**

(54) Einrichtung zur ortsaufgelösten Untersuchung einer Probe mittels magnetischer Resonanz von Spinmomenten.

(30) Priorität: **14.12.84 DE 3445689**

(43) Veröffentlichungstag der Anmeldung:
**18.06.86 Patentblatt 86/25**

(45) Bekanntmachung des Hinweises auf die Patenterteilung:
**24.05.89 Patentblatt 89/21**

(84) Benannte Vertragsstaaten:
**AT BE CH DE FR GB IT LI LU NL SE**

(56) Entgegenhaltungen:
DE-A- 2 755 091
DE-A- 3 310 160
GB-A- 2 126 731
US-A- 3 530 373

PHYSICS IN MEDICINE AND BIOLOGY, Band 28, Nr. 6,
Juni 1983, Seiten 723-729, Bristol, GB; I.L. PYKETT et al.:
"Measurement of spin-lattice relaxation times in
nuclear magnetic resonance imaging"
ANGEWANDTE CHEMIE, Band 95, 1983, Seiten 381-411,
Weinheim; R. BENN et al.: "Moderne Pulsfolgen in der
hochauflösenden NMR-Spektroskopie"

(73) Patentinhaber: **Max-Planck-Gesellschaft zur Förderung
der Wissenschaften e.V., Bunsenstrasse 10,
D-3400 Göttingen(DE)**

(72) Erfinder: **Frahm, Jens, Dr., Beethoven Strasse 25,
D-3400 Göttingen(DE)**
Erfinder: **Haase, Axel, Dr., Stiegel 5,
D-3400 Göttingen(DE)**
Erfinder: **Haenicker, Wolfgang, Gartenstrasse 3,
D-3400 Göttingen(DE)**
Erfinder: **Merboldt, Klaus-Dietmar, Dr., Brunnengasse 2,
D-3400 Göttingen(DE)**
Erfinder: **Matthaei, Dieter, Dr., Hansenstrasse 17,
D-3400 Göttingen(DE)**

(74) Vertreter: **von Bezold, Dieter, Dr. et al, Dr. Dieter von
Bezold Dipl.-Ing. Peter Schütz Dipl.-Ing. Wolfgang
Heusler Brienner Strasse 52, D-8000 München 2(DE)**

**Beschreibung**

Die vorliegende Erfindung betrifft eine Einrichtung zur ortsaufgelösten Untersuchung eines Objekts mittels magnetischer Resonanz von Spinmomenten, mit einer Vorrichtung zum Erzeugen eines konstanten Magnetfeldes im Objekt; Vorrichtungen zum Erzeugen einer variablen Kombination von drei im wesentlichen aufeinander senkrecht stehenden Gradienten-Magnetfeldern im Objekt; einer Vorrichtung zum Beaufschlagen des Objekts mit einer Folge von Hochfrequenzpulsen, die drei aufeinanderfolgende Pulse mit Flipwinkeln ungleich $\lceil m\pi\rceil$ enthält; einer Vorrichtung zur Erfassung von Signalen entsprechend einer magnetischen Resonanz von Spinmomenten im Objekt und einer Steuereinrichtung für die genannten Vorrichtungen. Die Erfindung betrifft in erster Linie Einrichtungen zur abbildenden Kernspin-Tomographie, sie ist jedoch nicht hierauf beschränkt, sondern läßt sich auch auf Elektronenspinresonanzgeräte anwenden.

Das Prinzip der Kernspin-Tomographie und anderer abbildender Kernspinresonanz-(NMR- bzw. KSR-)Verfahren ist beispielsweise in einer Veröffentlichung von I.L. Pykett in der Zeitschrift "SCIENTIFIC AMERICAN", May 1982, S. 54 bis 64 bzw. "Spektrum der Wissenschaft", Juli 1982, S. 40 bis 55 beschrieben, auf die hier ausdrücklich Bezug genommen wird. Auch bei den mit der vorliegenden Einrichtung gewonnenen Spinresonanzdaten kann, wie in dieser Veröffentlichung beschrieben, die Bildrekonstruktion nach dem Prinzip der Fourier-Zeugmatographie erfolgen, wie es anhand von Bild 8 dieser Veröffentlichung erläutert ist. Entsprechende Erläuterungen finden sich in der Veröffentlichung von P. Mansfield und I.L. Pykett im "Journal of Magnetic Resonance" 29, 355–373 (1978).

Kernspinresonanz- oder NMR-Verfahren, bei denen stimulierte Echoimpulse erzeugt werden, sind in der Veröffentlichung von E.L. Hahn, "Physical Review" 80, 4, Nov. 15, 1950, S. 580 ff und von J.E. Tanner im "The Journal of Chemical Physics" 52, Nr. 5, 1. März 1970, S. 2523–2526 beschrieben. Bei diesen bekannten Verfahren, bei denen es sich jedoch um nichtabbildende, intergrale Verfahren zum Messen bestimmter Probenparameter, wie Relaxationszeiten oder Diffusionskoeffizienten handelt, läßt man auf die Probe drei nicht-selektive ("harte") Hochfrequenzpulse einwirken, d.h. hochfrequente Schwingungszüge mit möglichst kurzer Dauer sowie möglichst großer Amplitude.

Es sind schließlich aus J. Chem. Phys. 64, 2229 (1976) auch hochauflösende zweidimensionale NMR-Verfahren (homonuklearer Kern-Overhauser-Effekt und chemischer Austausch) bekannt, die zwar auch drei Hochfrequenzpulse benutzen, jedoch kein stimuliertes Echo detektieren und auch nicht zur Bilderzeugung benutzt werden (keine Gradientenschaltungen).

Der vorliegenden Erfindung liegt die Aufgabe zugrunde, eine Einrichtung zur ortsaufgelösten Untersuchung eines Objekts ("Probe") mittels magnetischer Resonanz von Spinmomenten, insbesondere von Kernspinmomenten, dahingehend weiterzubilden, daß schnellere und/oder bisher nicht mögliche orts- und/oder linienselektive, abbildende Messungen durchgeführt werden können.

Diese Aufgabe wird bei einer Einrichtung der eingangs angegebenen Art erfindungsgemäß dadurch gelöst, daß die Steuereinrichtung die genannten Vorrichtungen mit einem Ablaufprogramm steuert, bei dem der Abstand $\tau$ zwischen dem ersten und dem zweiten Puls größer als $T_{2eff}$ und kleiner als $5T_2$, z.B. kleiner als $2T_2$ ist und der Abstand $T-\tau$ zwischen dem zweiten und dem dritten Puls größer als $T_{2eff}$ und kleiner als $5T_1$, z.B. kleiner als $3T_1$ ist, wobei

m eine ganze Zahl,
$T_1$ die Spin-Gitter-Relaxationszeit,
$T_2$ die Spin-Spin-Relaxationszeit und
$T_{2eff}$ die effektive Spin-Spin-Relaxationszeit der
zu bestimmenden Spins in der Probe sind, mindestens eines der Gradientenfelder zwischen dem ersten und/oder dem zweiten Puls und/oder dem zweiten und dem dritten Puls und/oder nach dem dritten Puls umgeschaltet wird, mindestens einer der Pulse ein frequenzselektiver Puls ist und mindestens ein durch den dritten Puls stimuliertes Echosignal erfaßt wird.

Weiterbildungen und vorteilhafte Ausgestaltungen der erfindungsgemäßen Einrichtung sind Gegenstand von abhängigen Ansprüchen.

Bei der vorliegenden Einrichtung liefert jedes Einzelexperiment ("Schuß"), d.h. jede Folge von mindestens drei Pulsen der angegebenen Art von denen zumindest die ersten beiden vorzugsweise sogenannte 90-Grad-Pulse ($\pi/2$-Pulse) sind, eine Mehrzahl von Signalen, so daß mehrere verschiedene Informationen für die Auswertung zur Verfügung stehen. Beispielsweise kann man Signale aus mehreren Ebenen, und/oder Signale für ein Nuklid mit unterschiedlicher chemischer Bindung (z.B. die Protonenspinresonanz von Wasser und Fett) und/oder unterschiedlich codierte Signale in schnellerer Aufeinanderfolge als bisher erzeugen, so daß eine Realzeit-NMR-Abbildung bewegter Strukturen, insbesondere sich bewegender Organe des menschlichen oder tierischen Körpers dargestellt werden können.

Die Vermeidung von 180-Grad-Pulsen bei der Erzeugung stimulierter Echosignale ist bei der vorliegenden Einrichtung wesentlich. Die Signalamplitude ist um so größer, je mehr sich die Energie der Hochfrequenzpulse derjenigen annähert, die einem Flipwinkel von genau 90 Grad entspricht. In vielen Fällen ist es jedoch zweckmäßig, zumindest den dritten Puls noch kleiner zu machen, so daß er nur einem Bruchteil des Flipwinkels von 90 Grad entspricht ("Bruchteilpuls").

Durch solche "Bruchteilpulse" kann die Information, die durch den zweiten Puls in der Form phasencodierter longitudinaler Magnetisierung gespeichert wurde, portionsweise abgerufen und selektiv verwertet werden. Ein weiterer Vorteil bestimmter Ausführungsformen der vorliegenden Einrichtung besteht darin, daß zwischen dem Zeitpunkt, in dem ein Gradientenfeld geschaltet wird und dem Auftreten eines Nutzsignales eine so große Zeitspanne verstreichen kann, daß die durch das Schalten der Gradientenfelder in einem statischen Magnetsystem induzierten Wirbelströme im wesentlichen abgeklungen sind. Weiterhin kann es zweckmäßig sein, die stimulierte Echosequenz durch zusätzliche 180-Grad-Pulse nach dem ersten Puls, oder dem dritten Puls zu ergänzen.

Bei der Einrichtung gemäß der Erfindung wirkt der zweite Puls im allgemeinen als Refokussierungspuls und erzeugt ein Spinecho (SE), dessen Abstand vom zweiten Puls gleich dem Abstand zwischen dem ersten und zweiten Puls ist. Der dritte Puls ist ein Lesepuls, der die durch den zweiten Puls gespeicherten Spins ganz oder teilweise um 90 Grad umklappt und dementsprechend ein stimuliertes Echo erzeugt. Es kann eine Folge von Leseimpulsen verwendet werden, die Summe der Bruchteile der Leseimpulse kann dabei einem Flipwinkel entsprechen, der wesentlich größer als 90 Grad ist.

Weitere Vorteile sind: Variabilität der Pulse, Intervalle und Gradientenschaltungen; Austauschbarkeit der Pulse; keine Verwendung frequenzselektiver 180-Grad-Pulse, kein zweites Kompensationsexperiment erforderlich, verbesserte Bandbreite der Hochfrequenz-(HF-)Anregung; wesentliche Verringerung der Meßdauer und/oder der erforderlilchen HF-Leistung; "Kompartimentierung" der longitudinalen Magnetisierung in phasencodierte und nicht-phasencodierte (relaxierte) Anteile; Unterscheidbarkeit der Signale in freien Iduktionsabfall (FID), Gradientenecho (GE), Spinecho (SE) und stimuliertes Echo (STE); Möglichkeit der unabhängigen Nutzung der in den Echos enthaltenen Informationen (z.B. Mehrfachcodierungen für Normal- und Zoom-Bilder oder Strömungsmessungen); "Portionierbarkeit" der phasencodierten longitudinalen Magnetisierung und Erzeugung entsprechender stimulierter Echos; Möglichkeit zur Kombination verschiedener bestimmter Ausführungsformen; Möglichkeit zur Kombination mit Verfahren zur Erzeugung von Spin-Echo-Signalen.

Im folgenden werden Ausführungsbeispiele der Erfindung unter Bezugnahme auf die Zeichnungen näher erläutert.

Alle Abbildungen zeigen Zeitdiagramme von Ablaufprogrammen der Steuereinrichtung und zwar (von oben nach unten)
— der auf die Probe zur Einwirkung gebrachten Hochfrequenz-(HF-)Pulse RF,
— der wesentlichen induzierten Ausgangssignale, die erfasst werden, und
— der Amplitude der drei Gradientenmagnetfelder, insbesondere des Schichtgradienten (G-Slice), des Phasengradienten (G-Phase) und des Lesegradienten (G-Read).

Von den Hochfrequenzpulsen ist in den Zeichnungen nur eine mögliche Hüllkurve dargestellt; rechteckige Hochfrequenzpulse stellen nicht-selektive HF-Pulse dar.

Bei der Darstellung der Gradientenpulse ist grundsätzlich nur eine spezielle Ausführungsform dargestellt. Die genaue Schaltweise, abweichend von der schematischen Darstellung, hängt von der Schaltdauer, der Amplitude und den Eigenschaften der Gradientenspulen und des Netzgerätes ab. Dabei sind die bekannten Bedingungen für das Refokussierungsverhalten von Schicht- und/oder Lesegradienten einzuhalten.

Bei der Darstellung des Phasengradienten ist durch waagerechte Striche die Änderung des Phasengradienten von Meßzyklus zu Meßzyklus bzw. Experiment zu Experiment (Schuß zu Schuß) angedeutet.

Fig. 1 bis 19 sind entsprechende Diagramme für Ausführungsformen der Erfindung, die Schichttomogramme mit einem Schichtpuls liefern;

Fig. 20 bis 32 sind entsprechende Diagramme für Ausführungsformen der Erfindung zum Erzeugen von Schicht-Tomogrammen mit zwei oder drei Schichtpulsen;

Fig. 33 bis 37 sind entsprechende Diagramme von Ausführungsformen der Erfindung für die Tomographie und lokalisierte Spinresonanz-Spektroskopie mit zwei oder drei ortsselektiven Pulsen (Schichtpulse) in unterschiedlichen Gradienten-Richtungen;

Fig. 38 und 39 sind Ausführungsformen der Erfindung, die Mehrschichttomogramme liefern, die eine effizientere Ausnutzung der Untersuchungszeit ermöglichen durch Messung einer großen Anzahl unmittelbar benachbarter und/oder beliebig entfernter Schichten bei kurzen Repetitionszeiten für die Einzelexperimente;

Fig. 40 bis 42 sind Ausführungsformen, die die Erzeugung einer Reihe von räumlich hochaufgelösten NMR-Tomogrammen entlang der $T_1$-Relaxationskurve in der Meßzeit eines einzigen Tomogrammes ermöglichen;

Fig. 43 bis 49 sind Ausführungsformen für die Aufnahme von NMR-Tomogrammen auf der Grundlage einzelner oder mehrerer Linien eines Kernresonanzspektrums;

Fig. 50 und 51 sind Ausführungsformen zur Erzeugung von Diffusions-NMR-Tomogrammen;

Fig. 52 bis 56 sind Diagramme für Ausführungsformen zum Erzeugen von Fluß-NMR-Tomogrammen;

Fig. 57 bis 59 sind Ausführungsformen zur Aufnahme von NMR-Tomogrammen, die sowohl räumliche als auch spektrale Information darstellen;

Fig. 60 bis 67 sind besonders schnell arbeitende Ausführungsformen der Erfindung, mit denen die Aufnahme von NMR-Tomogrammen mit einer einzigen Anregung und mit Meßzeiten zwischen ca. 100 ms und 1 bis $2T_1$ bei variabler räumlicher Auflösung möglich ist;

Fig. 68 bis 71 zeigen die Pulssequenzen von vier speziellen, bevorzugten Ausführungsbeispielen der Erfindung;

Fig. 72 zeigt schematisch das Prinzip eines NMR-Gerätes, mit dem die Ablaufprogramme gemäß Fig. 1 bis 71 durchgeführt werden können.

Die erfindungsgemäßen Einrichtungen können bekannten Spinresonanzgeräten, insbesondere NMR-Geräten, entsprechen, lediglich das Steuergerät, welches die Gradienten-Magnetfelder und die anregenden Hochfrequenz-Pulse bestimmt und schaltet, ist so abgewandelt, daß es Funktionen ("Ablaufprogramme") entsprechend einem oder wahlweise einem von mehreren Ausführungsformen der vorliegenden Erfindung auszuüben vermag. Vorteilhafte und bevorzugte Ausführungsbeispiele solcher Ablaufprogramme werden im folgenden erläutert.

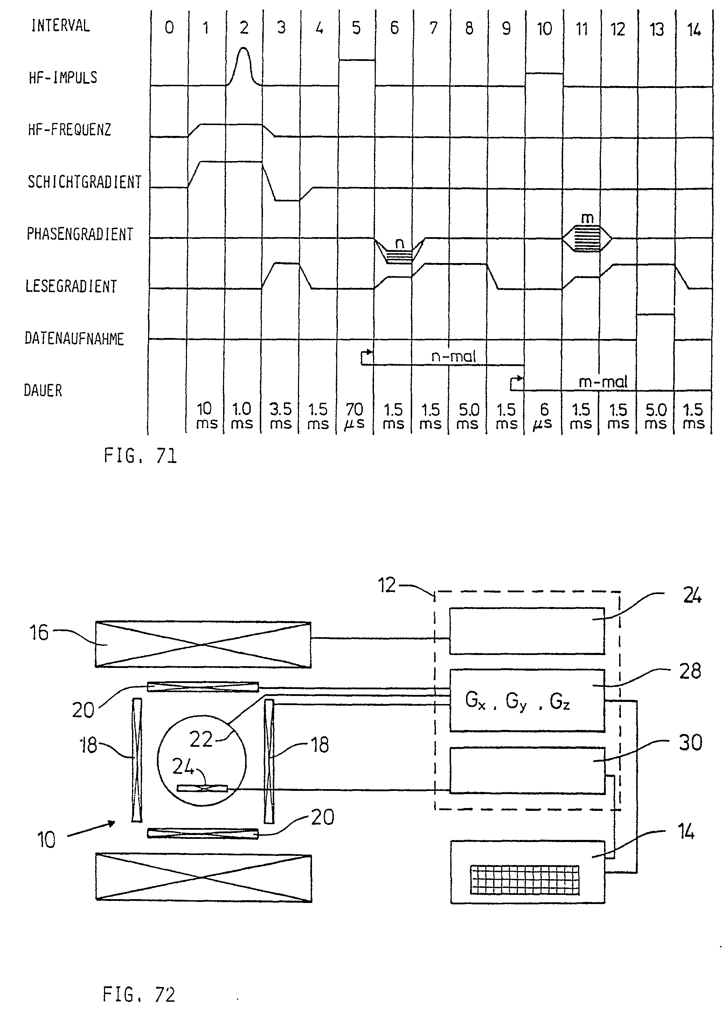

Wie in Fig. 72 schematisch dargestellt ist, enthält ein übliches NMR-Gerät einen Meßkopf 10, einen Stromversorgungsteil 12 und einen Steuerteil 14. Der Meßkopf 10 des Gerätes kann, wie üblich, einen Magneten 16 zum Erzeugen eines konstanten, homogen $B_0$-Feldes enthalten, ferner Spulensätze 18, 20, 22 zum Erzeugen von drei im wesentlichen aufeinander senkrecht stehenden, im allgemeinen lineare Gradienten aufweisenden "Gradienten"-Magnetfeldern, und einer Spulenanordnung 24, der Hochfrequenzpulse zugeführt werden. Der Magnet 16 kann mit einer Erregungseinheit 26 gekoppelt werden.

Die Gradientenspulen 18, 20 und 22 sind mit einer Stromversorgungsschaltung 28 gekoppelt, die durch den Steuerteil 14 steuerbar ist und die Ströme in den Gradientenspulen individuell zu steuern gestattet. Die HF-Spulenanordnung 24 wird durch einen HF-Generator 30 gespeist, der ebenfalls durch den Steuerteil gesteuert ist, so daß die Spulenanordnung 24 Hochfrequenzimpulse mit einer gewünschten Dauer, Amplitude, Hüllkurve, in einer gewünschten zeitlichen Folge zugeführt werden können.

Unter den Begriff "Hochfrequenzpuls" sollen sowohl ein Schwingungszug vorgegebener Frequenz mit rechteckiger oder beliebiger Hüllkurve, der, wenn er kurz ist und eine hohe Amplitude hat, als nicht-selektiver ("harter") Puls bezeichnet wird, fallen, ferner ein frequenzmodulierter Hochfrequenzschwingungszug, weiterhin eine Folge voneinander beabstandeter, relativ kurzer Hochfrequenzschwingungszüge, die gleiche oder unterschiedliche Schwingungsfrequenzen aufweisen können und als Ganzes einen vorgegebenen Flipwinkel ergibt. Dieser Winkel ist bei den ersten beiden Pulsen, gleichgültig welche der obenerwähnten Konfigurationen sie jeweils haben, vorzugsweise 90 Grad, da dies die größten Signale liefert. Ein "frequenzselektiver" Puls ist ein Puls, wie ein Schicht-Puls (Slice-Puls), ein Streifen-Puls (Stripe-Puls), ein Auswahl- oder Zoom-Puls oder ein resonanz-linienselektiver Puls (Line-Puls), der gegebenenfalls im Zusammenwirken mit Gradientenfeldern eine Orts- oder Frequenzselektion ermöglicht.

$T_1$ ist die Spin-Gitter-Relaxationszeit, welche bei biologischen Proben größenordnungsmäßig eine Sekunde betragen kann und bei dem vorliegenden Verfahren in erster Linie ausgenutzt wird.

$T_2$ ist die natürliche Spin-Spin-Relaxationszeit.

$T_{2eff}$ ist die effektive Spin-Spin-Relaxationszeit.

Bei der vorliegenden Einrichtung wird mit einer Pulsfolge gearbeitet, welche drei Pulse enthält, die jeweils einem Flipwinkel ungleich 180 Grad entsprechen. Der ideale Flipwinkel, zumindest für die ersten beiden Pulse, ist 90 Grad und generell gilt, daß das Nutz-Ausgangssignal um so größer wird, je näher der Flipwinkel an 90 Grad liegt.

Der Abstand Tau zwischen dem ersten und dem zweiten Puls soll größer als $T_{2eff}$ und kleiner als $5T_2$, z.B. kleiner als $2T_2$ sein. Der Abstand T–Tau zwischen dem zweiten und dem dritten Puls soll größer als $T_{2eff}$ und kleiner als $5T_1$, z.B. kleiner als $3T_1$ sein. Mit zunehmendem Abstand zwischen dem zweiten und dritten Puls nimmt auch die Amplitude der auf den dritten und etwaige weitere Pulse folgenden Ausgangssignale, bei denen es sich um stimulierte Spin-Echosignale (STE) handelt, ab.

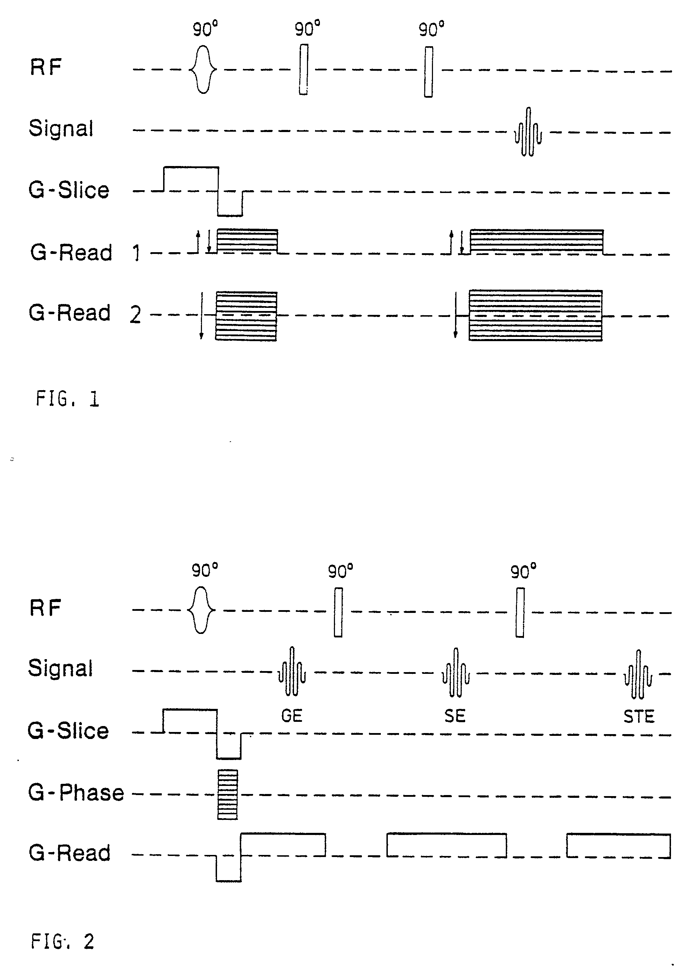

Fig. 1 zeigt den zeitlichen Verlauf der verschiedenen Pulse, Signale und Gradientenfelder für eine Ausführungsform der vorliegenden Erfindung, bei dem eine Projektionsrekonstruktionsabbildung unter Verwendung des stimulierten Spin-Echos STE als Nutzsignal stattfindet. Der erste Puls ist ein selektiver 90-Grad-Schichtpuls, der zweite und der dritte Puls ist jeweils ein nicht-selektiver Puls. Die Lesegradienten (G-Read 1, G-Read 2) werden synchron und schrittweise von Einzelaufnahme zu Einzelaufnahme in Pfeilrichtung geändert. Sie nehmen dabei Werte an, die durch die waagerechten Linien angedeutet sind.

Bei dieser Ausführungsform lassen sich Ausschnitt-Vergrößerungen ohne Faltungsprobleme erzeugen. Der resultierende Lesegradient ist während der HF-Pulse gleich null.

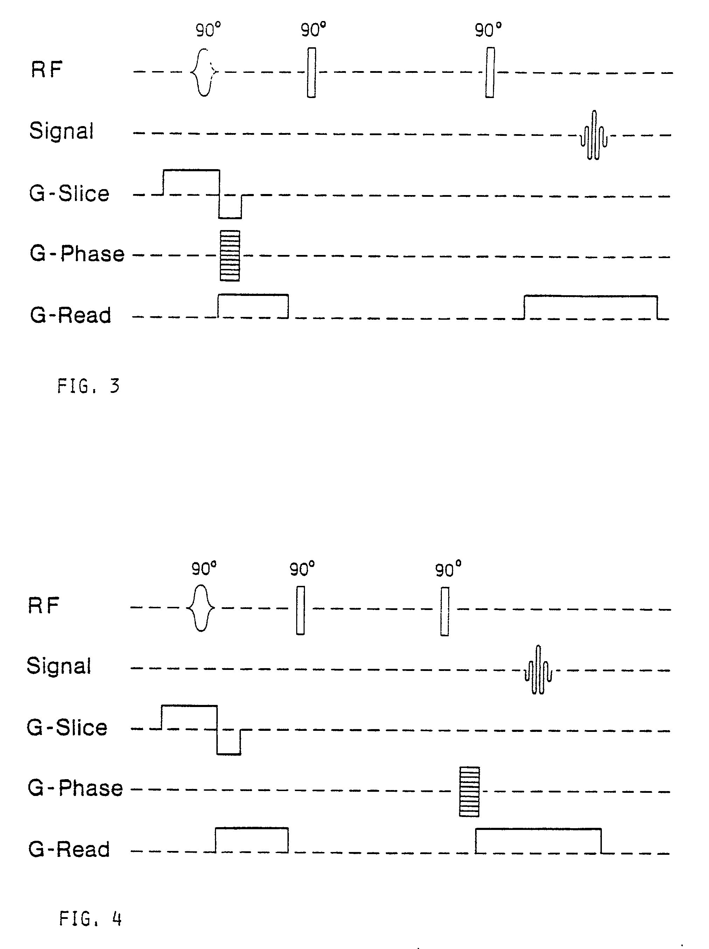

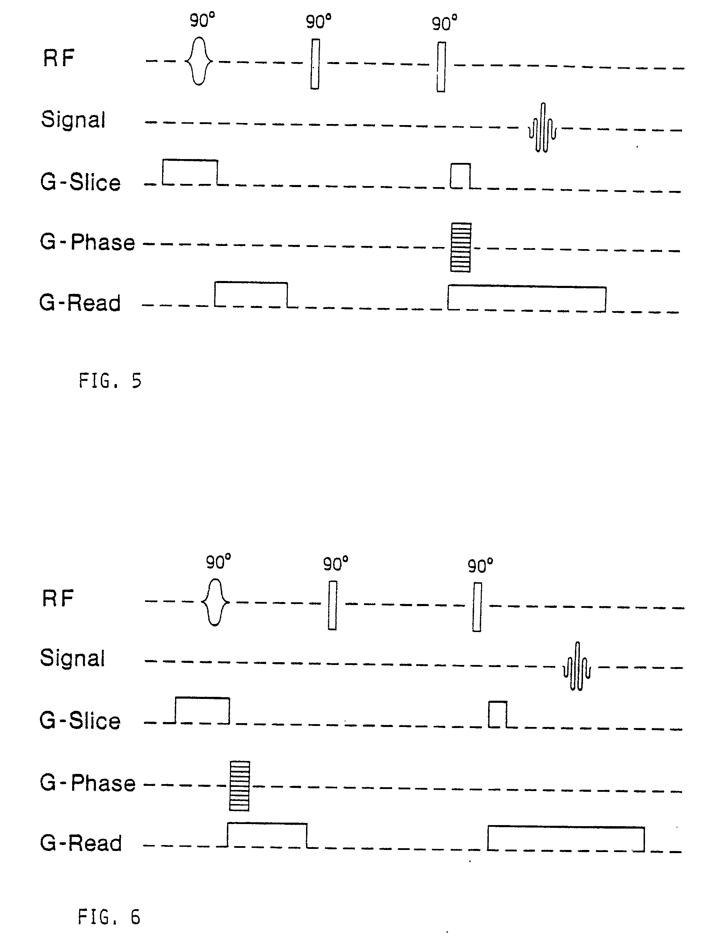

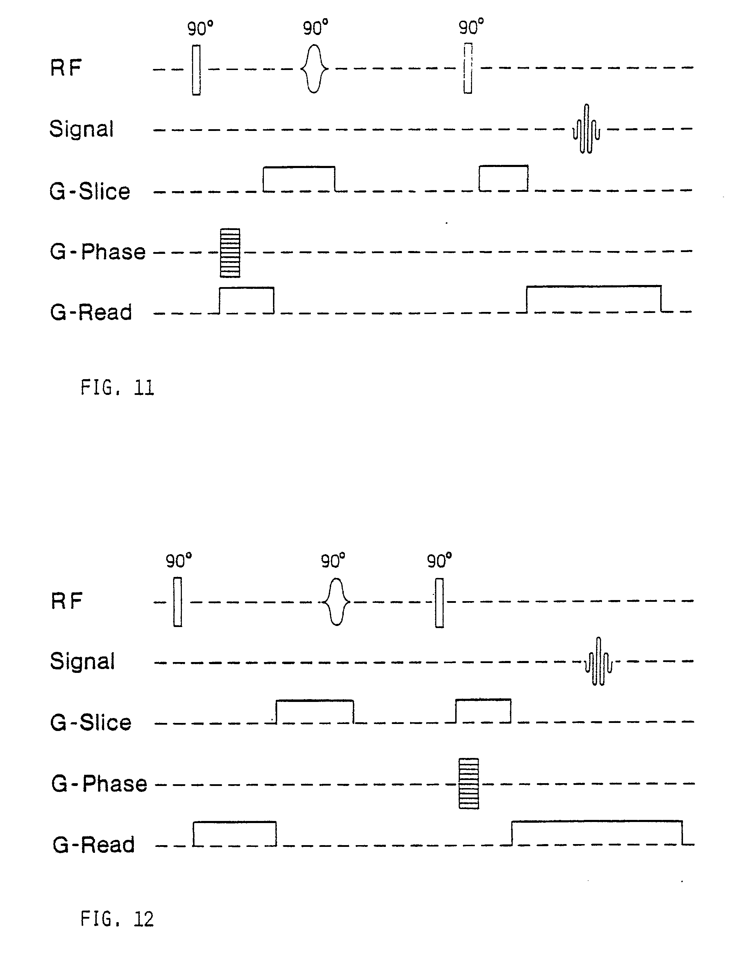

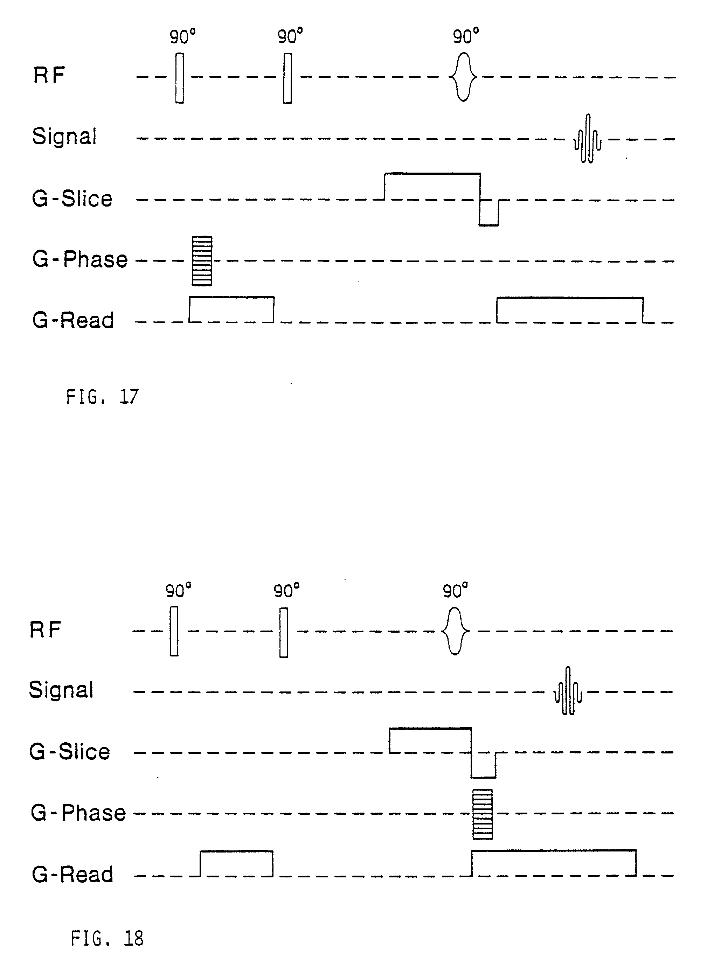

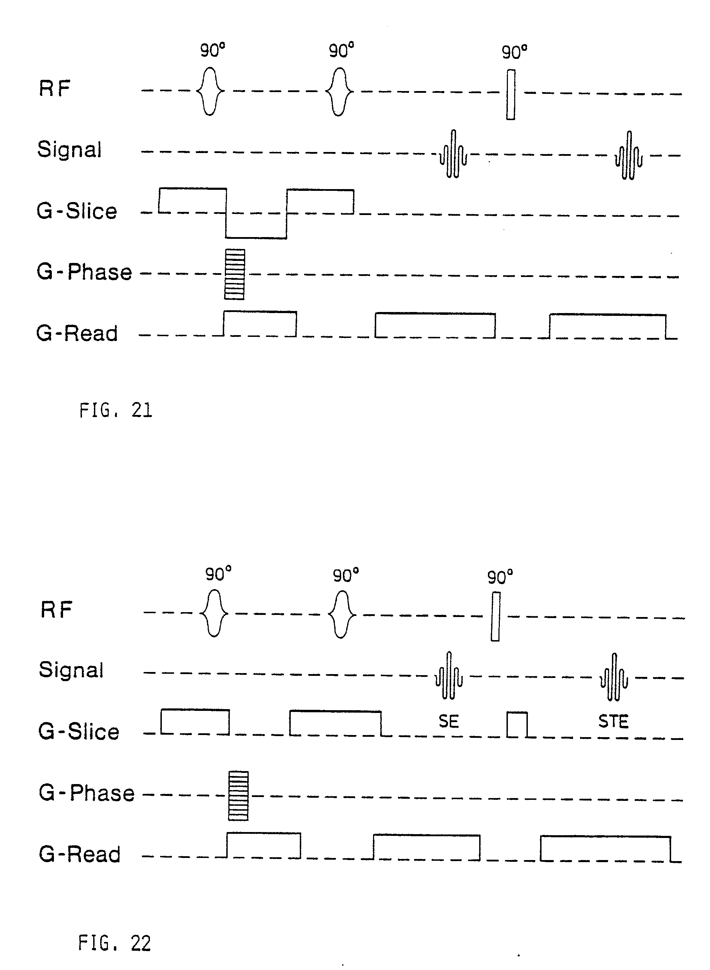

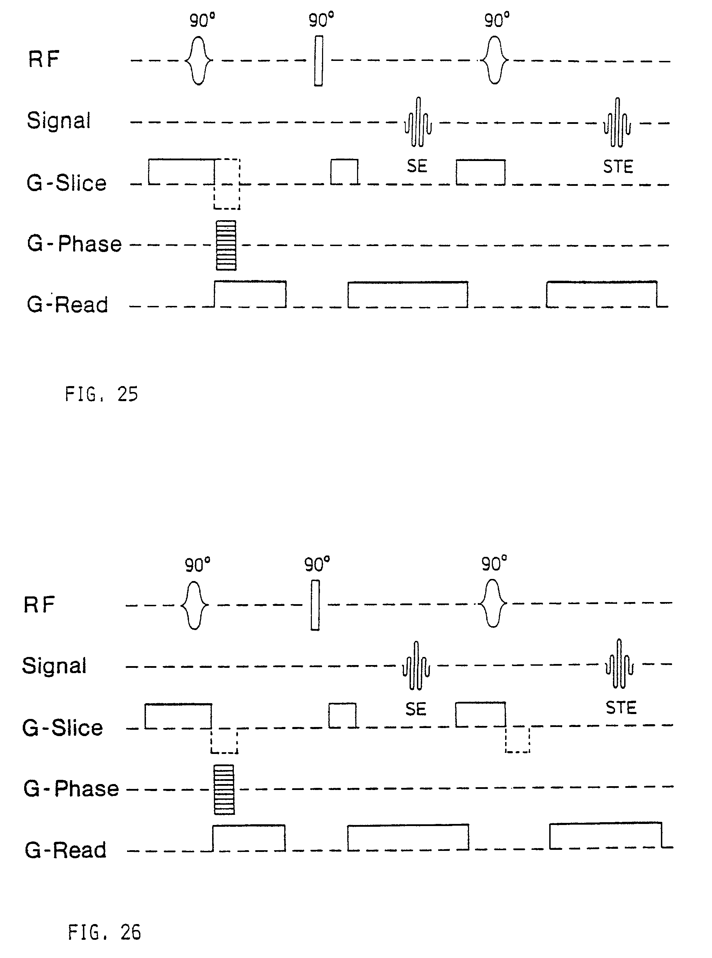

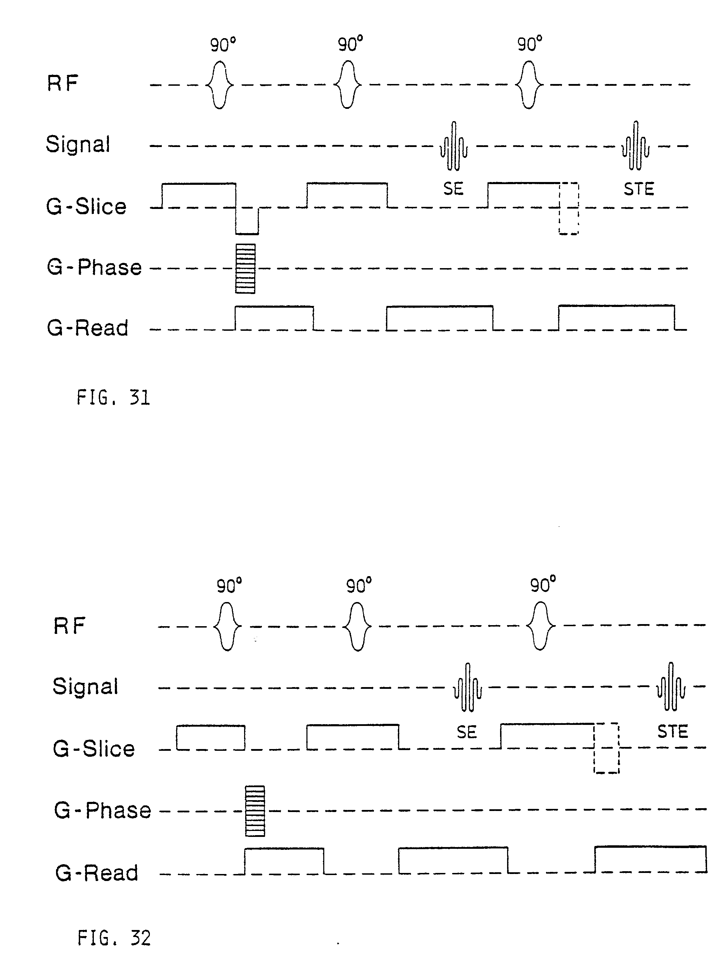

Die folgenden Ausführungsformen gem. Fig. 2 bis 67 werden auf der Grundlage des Fourier-Imaging erläutert.

Bei den Ausführungsformen gemäß Fig. 2 bis 19 ist eine Datenaufnahme durch Erfassung des Gradientenechos GE, des Spinechos SE und des stimulierten Spinechos STE möglich; selbstverständlich brauchen nicht alle Echo-Signale verwendet zu werden.

Die Fig. 2 bis 7 zeigen verschiedene Varianten, bei denen der Schichtpuls der erste Puls ist und der Schicht- sowie der Phasen-Gradient variabel sind.

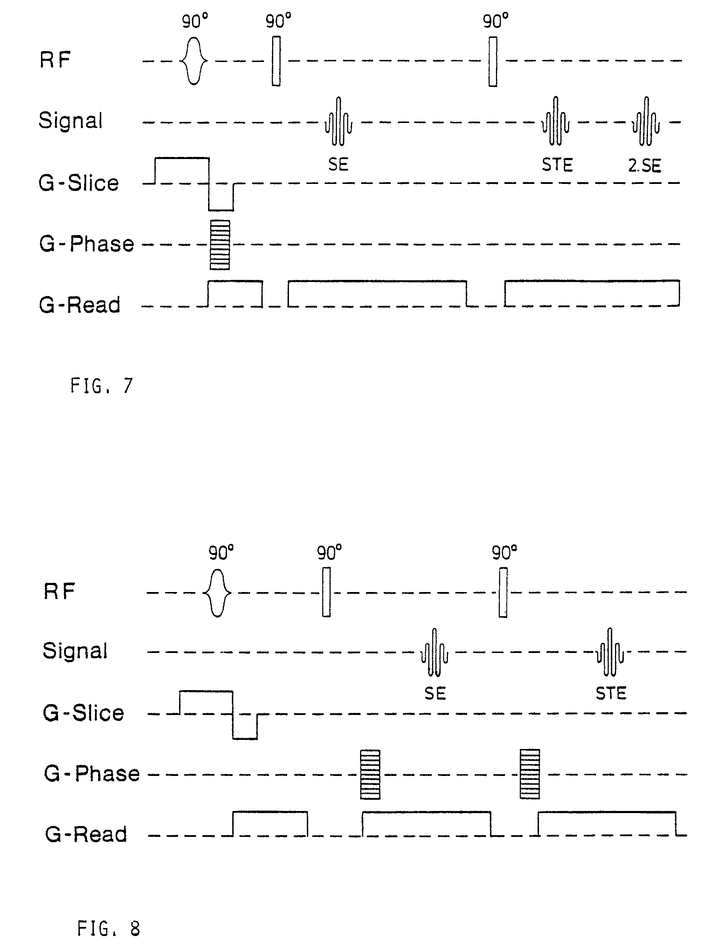

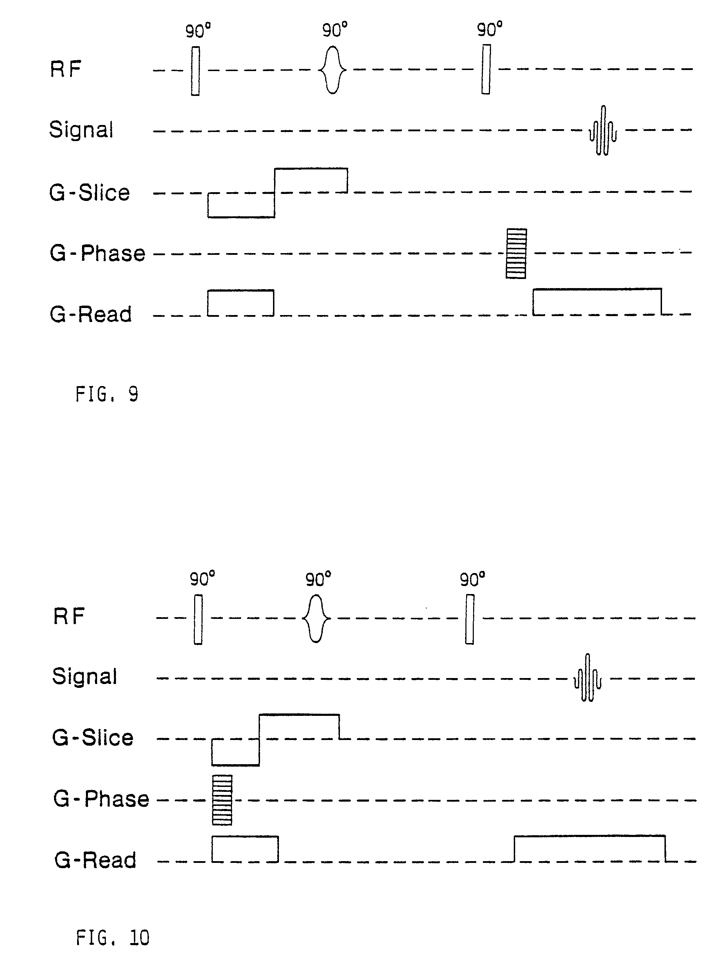

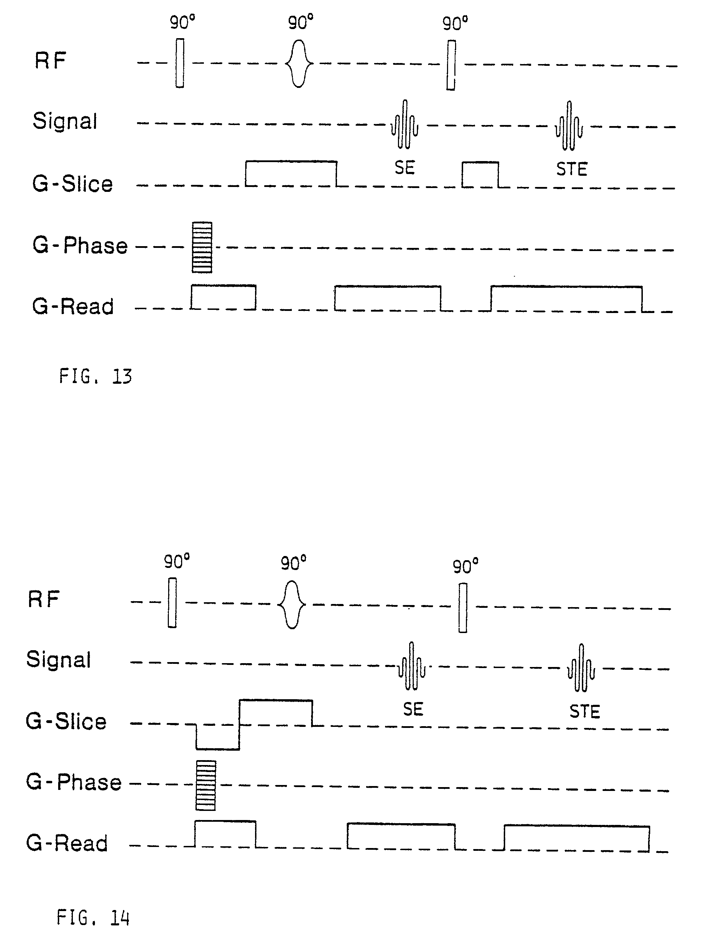

Bei der Ausführungsform gemäß Fig. 8 sind die mit Hilfe des zweiten und des dritten HF-Pulses erzeugten Bilder unabhängig voneinander. Die Figuren 9 bis 14 zeigen entsprechende Ausführungsformen bei denen der Schichtpuls der mittlere Puls ist. Bei Fig. 13 und 14 erfolgt eine Mehrfachecho-Abbildung.

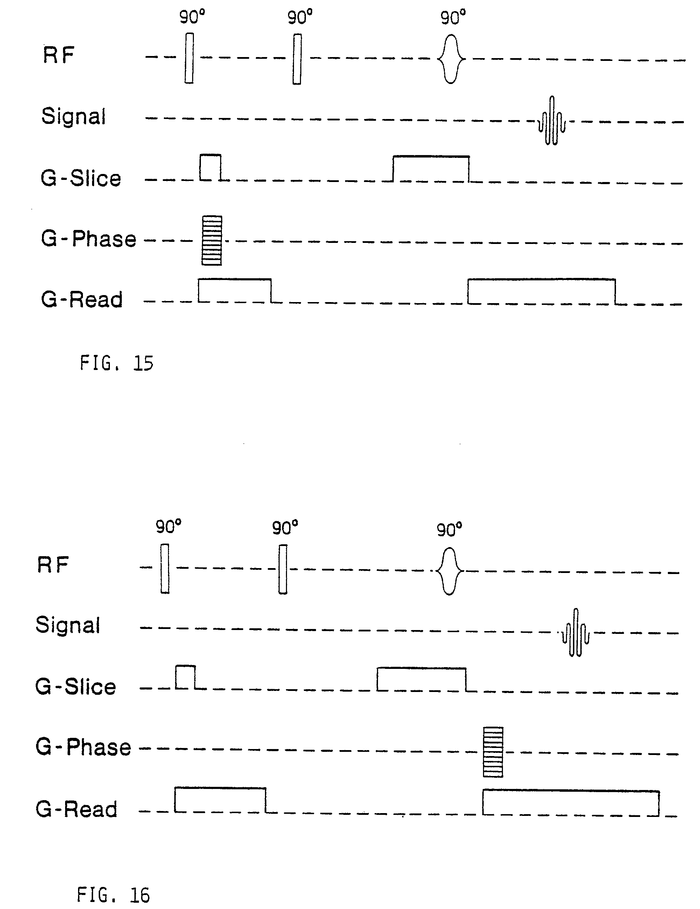

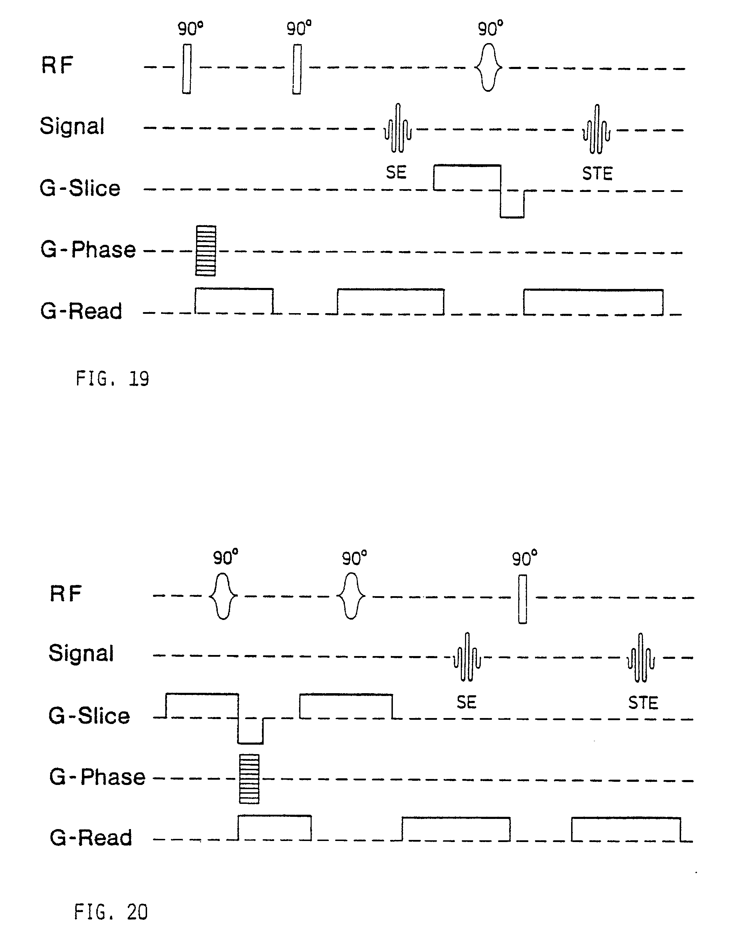

Die Figuren 15 bis 19 betreffen Ausführungsformen, bei denen der Schichtpuls der dritte Puls ist. Hier liefert das nur in Fig. 19 eingezeichnete SE-Signal ein Durchleuchtungsbild, da die ersten beiden Pulse nicht selektiv sind und daher vor der Erzeugung des SE-Signales keine Schichtselektion stattfindet.

Die Figuren 20 bis 32 betreffen Ausführungsformen zur Erzeugung von Schichttomogrammen mittels zweier oder dreier Schichtpulse.

Zwei Schichtpulse beziehen sich auf die gleiche Schicht.

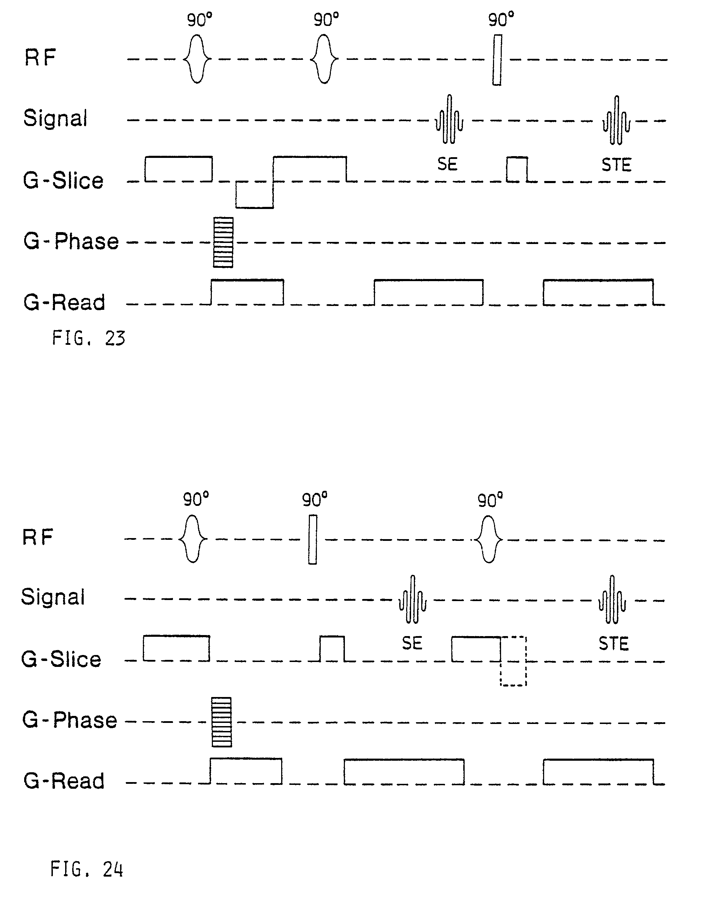

Die Figuren 20 bis 23 zeigen Varianten mit Schichtpulsen als erster (vorderer) und zweiter (mittlerer) Puls. Die Figuren 24 bis 27 zeigen Varianten bei denen der erste und der dritte Puls ein Schichtpuls ist.

Die gestrichelten Teile des Schichtgradientenfeldes (G-Slice) heben sich in ihrer Wirkung gegenseitig auf und können daher weggelassen werden, wie ausgezogen gezeichnet ist.

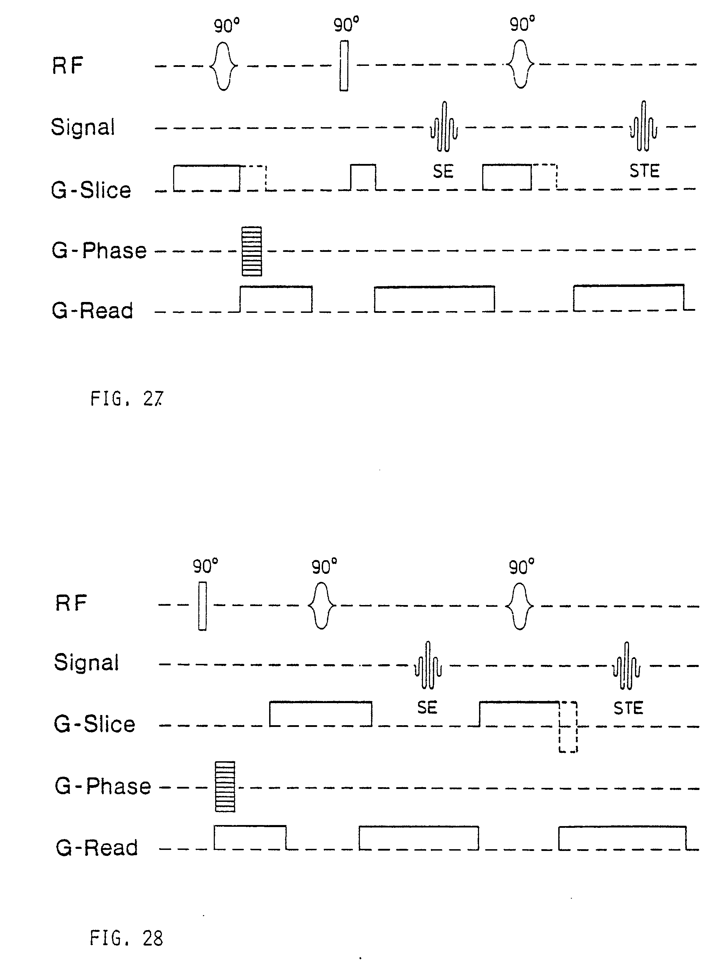

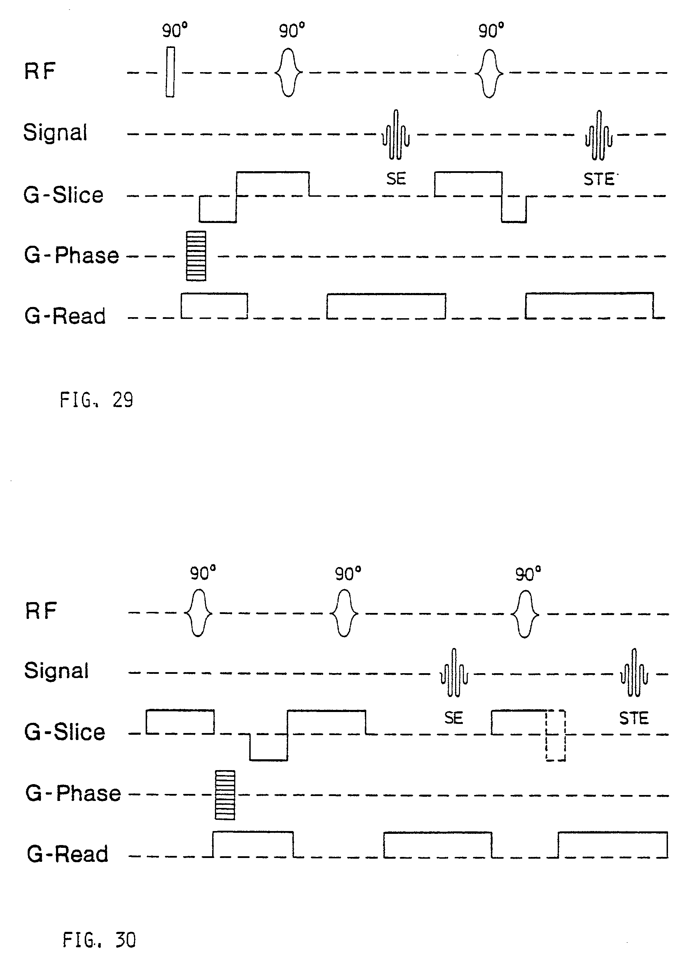

Die Figuren 28 und 29 zeigen Varianten, bei denen der zweite und der dritte Puls jeweils ein Schichtpuls ist. In Fig. 28 sind wieder die sich aufhebenden Teile des Schichtgradientenfeldes gestrichelt dargestellt.

Die Figuren 30 bis 32 zeigen Ausführungsformen mit drei Schichtpulsen.

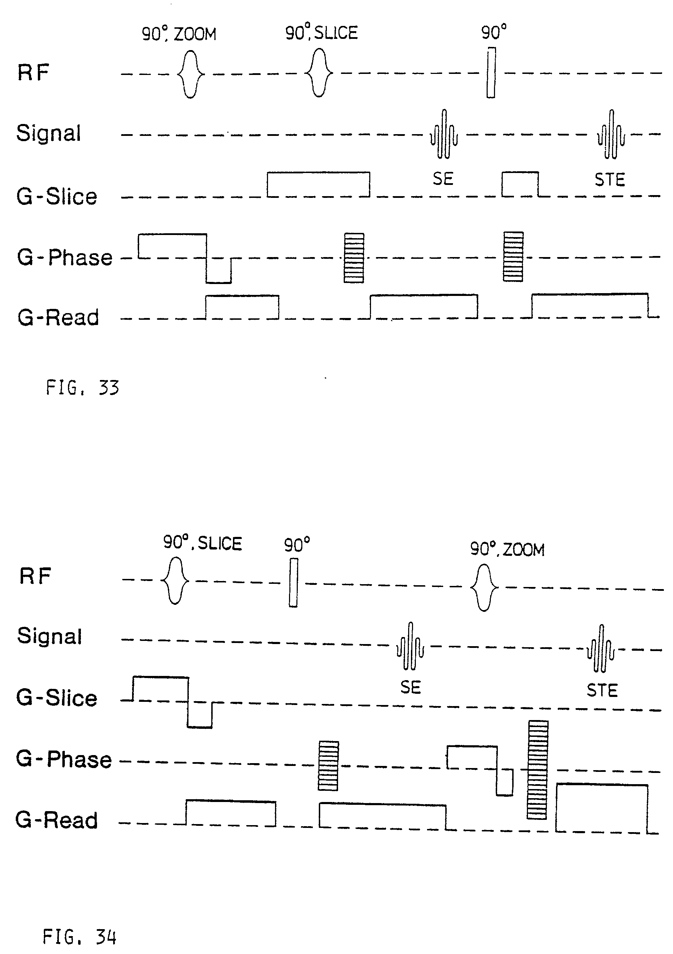

Die Figuren 33 bis 37 zeigen, wie die vorliegende Erfindung für eine lokalisierte Spektroskopie und Tomographie mit zwei oder drei ortsselektiven Pulsen (Schichtpulsen) in unterschiedlichen Gradientenrichtungen verwendet werden kann. Insbesondere können Zoom- oder Ausschnitt-Tomogramme, eine gleichzeitige Aufnahme von Übersichts- und Zoom-Tomogrammen und eine Punkt-Spektroskopie durchgeführt werden. Die dargestellten nicht-selektiven Pulse können durch frequenzselektive Pulse ersetzt werden.

Die Ausführungsformen gemäß Fig. 33 und 34 betreffen Ablaufprogramme zur Zoom-Tomographie in Kombination mit Übersichts-Tomogrammen. Bei der Zoom-Tomographie kann ein Streifen in einer ausgewählten Schicht vergrößert dargestellt werden.

Das Ablaufprogramm gemäß Fig. 34 liefert normale Spinecho-Bilder und Ausschnitts-(Zoom-)-STE-Bilder.

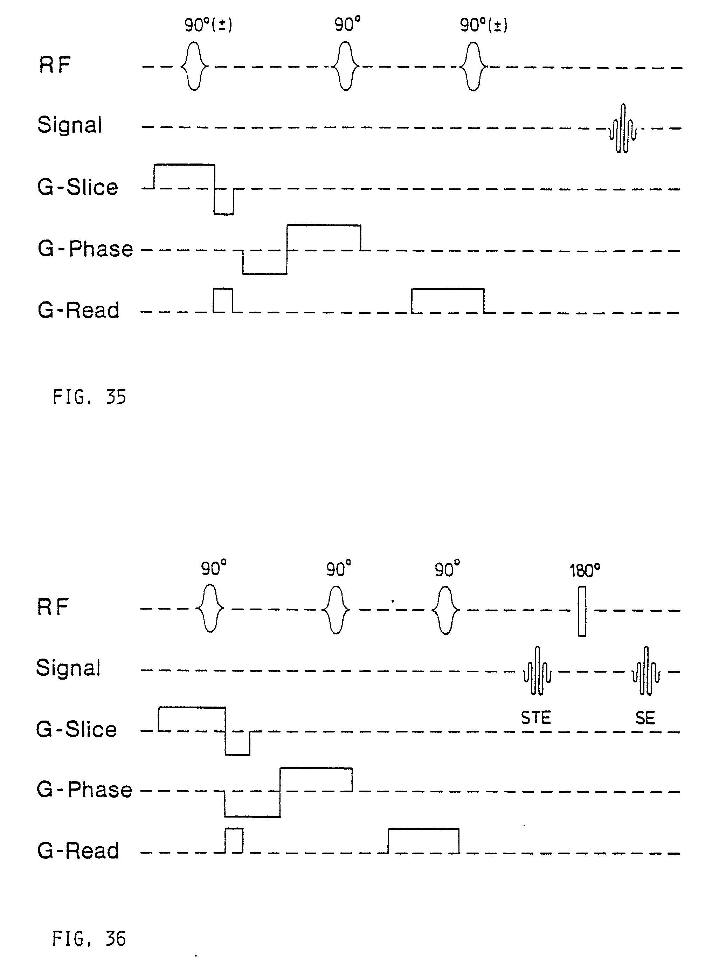

Das Ablaufprogramm gemäß Fig. 35 dient zur Punkt-Spektroskopie und arbeitet mit drei Schichtimpulsen. Die Phasenbeziehung zwischen dem ersten und dem dritten Schichtpuls kann bei Addition bzw. Subtraktion mehrerer Einzelexperimente mit geeigneten Phasenlagen (hier ein einfaches Beispiel angedeutet) zur Unterdrückung von unerwünschten Signalen herangezogen werden. Aus dem STE-Signal, das ohne Gradient ausgelesen wird, läßt sich in bekannter Weise durch Fourier-Transformation das Resonanzlinienspektrum gewinnen.

Fig. 36 betrifft ein Ablaufprogramm zur lokalisierten STE-Spektroskopie, bei dem der auf eine bestimmte Resonanzlinie, z.B. von Wasser berührende Signalanteil durch $T_1$- und $T_2$-Diskrimination unterdrückt werden kann. Welche Linie ausgelöscht wird, hängt vom TAU und T–TAU sowie vom Abstand zwischen dem 1. STE und dem 180-Grad-Puls ab.

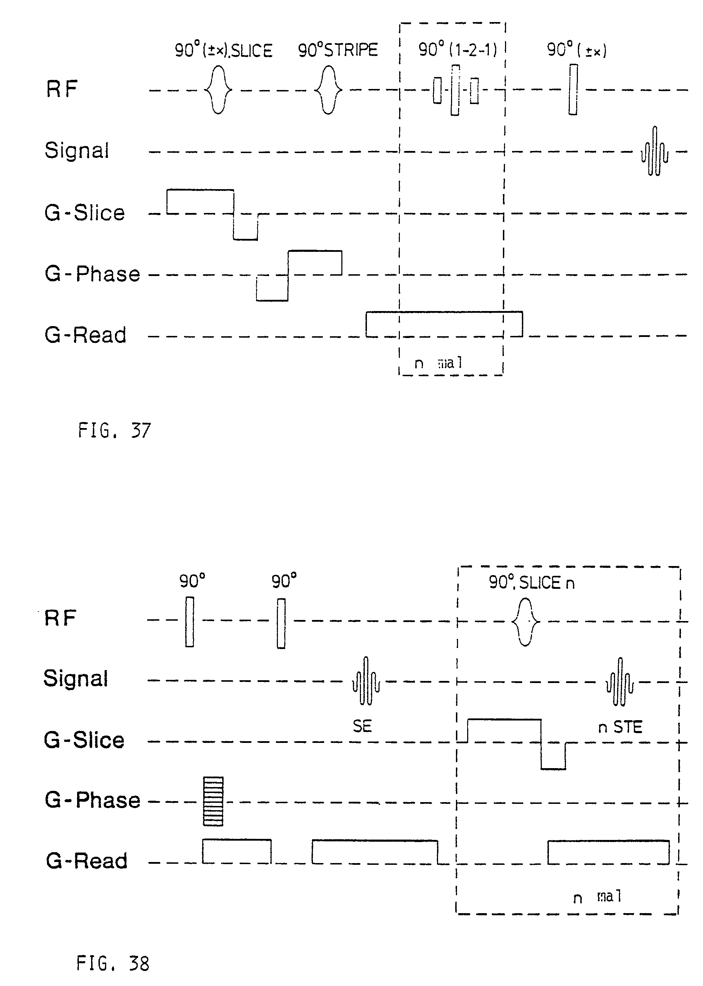

Bei Fig. 37 wird zwischen dem zweiten und dem dritten Puls eine Impulsfolge mit einem Gradienten angewendet, die aus dem in der longitudinalen Magnetisierung gespeicherten Streifen Magnetisierungsanteile so anregt und dephasiert, daß ein Punkt übrig bleibt, dessen Spektrum mit dem dritten Puls in der Form eines stimulierten Echos ausgelesen werden kann.

Es erfolgt also eine Punkt-Spektroskopie mit zwei Schichtpulsen bzw. einem Schicht- und einem Streifenpuls und einer Fokussierung durch nichtselektive ("harte") Pulspakete (z.B. wie dargestellt mit den Amplitudenverhältnissen 1–2–1) in der dritten Dimension.

Eine gleichzeitige Aufnahme von Ausschnitts- oder Zoom- und Übersichtsbildern war bisher nicht realisierbar. Die Signalverluste bei der Punkt-Spektroskopie werden wegen der $M_z$-Speicherung

zwischen dem zweiten und dritten Puls minimiert. Die Version gemäß Fig. 37 gestattet es, den Abfall der durch das Schalten der Gradienten entstandenen Wirbelstromeffekte in der $B_0$-Spule abzuwarten und ihren Einfluß dadurch auf die NMR-Spektren auszuschalten.

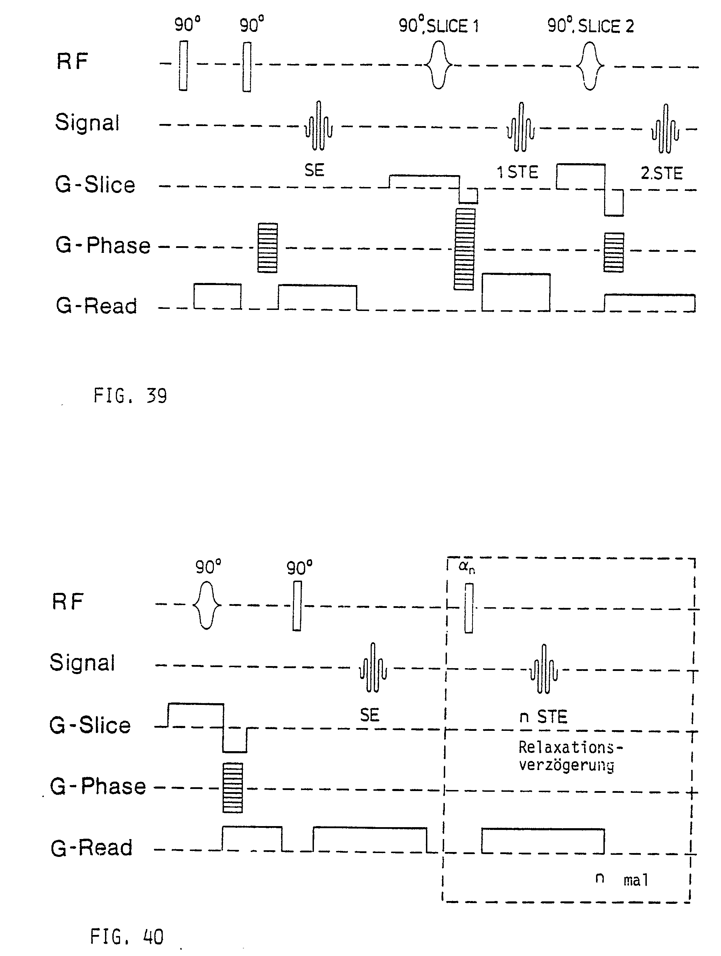

Die Figuren 38 und 39 betreffen Verfahren zum Herstellen von Mehrschicht-Tomogrammen mit gleichzeitiger Aufnahme eines Durchleuchtungsbildes. Nicht-selektive Impulse können durch frequenzselektive Pulse ersetzt werden.

Fig. 38 ist eine typische Version zur Erzeugung von Mehrschicht-Tomogrammen. Das Ablaufprogramm gemäß Fig. 39 gestattet es, voneinander unabhängige Mehrschicht-Tomogramme zu erzeugen. Die ersten beiden Pulse sind jeweils nicht-selektive Pulse und regen dementsprechend das ganze Spektrum an. Alternativ können hier auch frequenzselektive Pulse verwendet werden, die bestimmte NMR-Frequenzen, jedoch ortsunabhängig, anregen. Das Durchleuchtungsbild wird aus dem Spin-Echo SE gewonnen. Der $T_1$-Kontrast der Mehrschicht-Tomogramme ist durch die Länge des zweiten Intervalls stufenlos variabel und unabhängig von der Repetitionszeit.

Durch das Ablaufprogramm gemäß Fig. 39 sind Einzelbilder erzeugbar, die hinsichtlich ihrer Koordinaten x, y, z unabhängig voneinander sind.

Im Gegensatz zu den bisher verwendeten Spin-Echo-Sequenzen ist es bei diesen Ablaufprogrammen möglich, direkt nebeneinanderliegende Schichten abzubilden. Ein weiterer Vorteil ist die Möglichkeit, die einzelnen Schichten schnell auslesen zu können (z.B. innerhalb von nur 20 bis 30 ms), so daß bei kurzen Repetitionszeiten von z.B. 0,5 Sekunden noch ca. 20 Schichten gemessen werden können. Ein weiterer, erheblicher Vorteil, der insbesondere bei höheren Frequenzen zum Tragen kommt, ist die geringe HF-Leistung, die pro Schicht appliziert werden muß (nur ein 90-Grad-Puls pro Schicht). Diese Mehrschicht-Verfahren stellen in vielen Fällen einen vollwertigen Ersatz für die erheblich zeitaufwendigeren 3D-Tomographieverfahren dar. Die Intensität der Mehrschichtaufnahmen nimmt mit $\exp(-(T-\text{Tau})/T_1)$ ab, wobei $(T-\text{Tau})$ das Intervall zwischen dem zweiten Puls und dem Schichtpuls bedeutet.

Die Figuren 40 bis 42 betreffen vorteilhafte Ausführungsformen, bei denen für die Erzeugung einer Bildserie entlang der $T_1$-Relaxationskurve nur die Meßzeit eines gewöhnlichen Tomogrammes erfordert. Für die Bestimmung der $T_1$-Relaxationszeiten sind beliebige Repetitionszeiten möglich.

Mit den Ablaufprogrammen gemäß Fig. 40 bis 42 ist eine Aufnahme einer Serie hochaufgelöster NMR-Tomogramme möglich, deren Intensität entsprechend der Funktion $\exp(-(T-\text{Tau})/T_1)$ abfällt.

Der dritte Puls wird hierzu durch eine Reihe aus mehreren "Bruchteilpulsen" $\text{Alpha}_n$ ersetzt, deren Flipwinkel kleiner oder gleich 90 Grad sind. Insbesondere kann der Flipwinkel, ausgehend von einem kleinen Wert, von Bruchteilpuls zu Bruchteilpuls vergrößert werden, um die Verringerung des gespeicherten Signals, das durch die Bruchteilpulse portionsweise gelesen wird, zu kompensieren. Gleiche Signalanteile werden gelesen bei einer Flipwinkel-Variation gemäß Alpha $_{n-1}$ = arctan (sin Alpha$_n$), z.B. Alpha$_1$ = 26.6 Grad, Alpha$_2$ = 30.0 Grad, Alpha$_3$ = 35.3 Grad, Alpha$_4$ = 45 Grad, Alpha$_5$ = 90 Grad für n = 5. Die Anzahl der Bruchteilpulse pro Sequenz kann bis zu 10 oder mehr betragen. Für die Bildserie ist nur ein Tomografie-Experiment oder -Meßzyklus mit einer wählbaren Repetitionszeit erforderlich. Nicht-selektive Pulse können durch frequenz-selektive Pulse ersetzt werden.

Das Ablaufprogramm gemäß Fig. 40 liefert ein normales SE-Bild und außerdem eine T$_1$-Bildserie aus einer Schicht entsprechend den STE-Signalen.

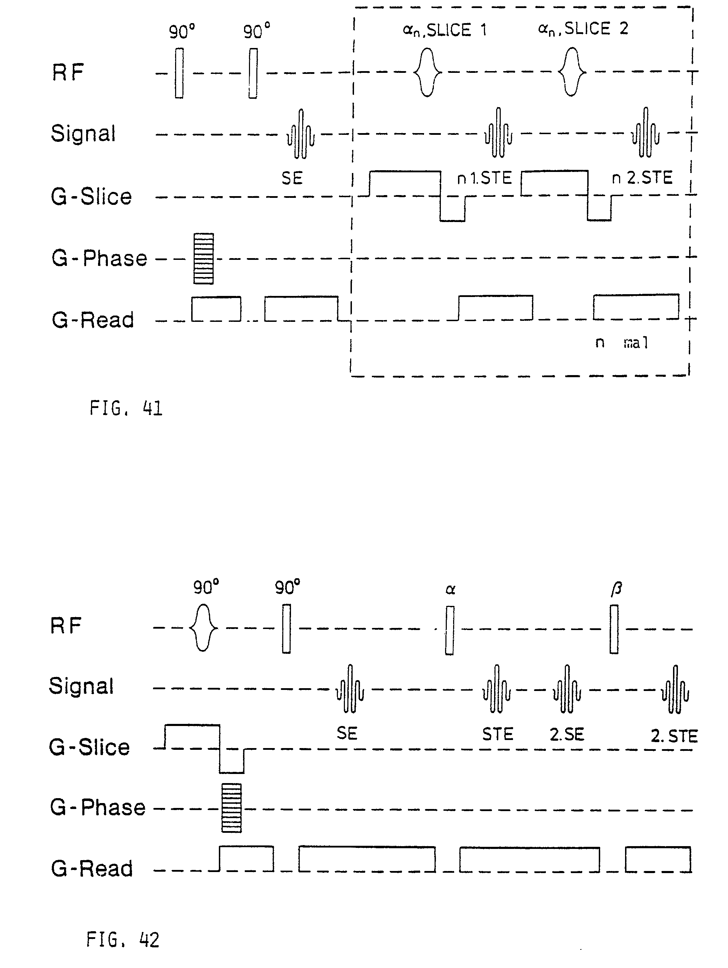

Fig. 41 zeigt eine Ausführungsform dieses Typs, die eine T$_1$-Bildserie aus mehreren Schichten liefert. Die Bruchteilpulse sind hier Schichtpulse, deren Frequenzgehalt von Bruchteilpuls zu Bruchteilpuls verschieden ist, um die verschiedenen Schichten zu selektieren.

Fig. 42 betrifft eine Ausführungsform mit einer Vierpuls-Sequenz für eine Zweipunkt-T$_1$- und eine Zweipunkt-T$_2$-Bestimmung aus vier Bildern. Bei Verwendung von Alpha = 45 Grad (3. Puls) und Beta = 90 Grad (vierter Puls) ergibt sich eine 50%-Aufteilung der Magnetisierung. Nicht-selektive Pulse können durch Schichtpulse ersetzt werden. In diesem Falle ist eine Mehrschichtvariante des Verfahrens möglich.

Es ist bisher kein Tomographieverfahren bekannt geworden, welches mit einem einzigen Experiment die Aufnahme einer Bildserie entlang der T$_1$-Relaxationskurve gestattet. Dieser Typ der vorliegenden Einrichtung ermöglicht daher eine erhebliche Verkürzung der Meßzeit und macht dementsprechend quantitative T$_1$-Messungen in klinischem Einsatz überhaupt erst möglich.

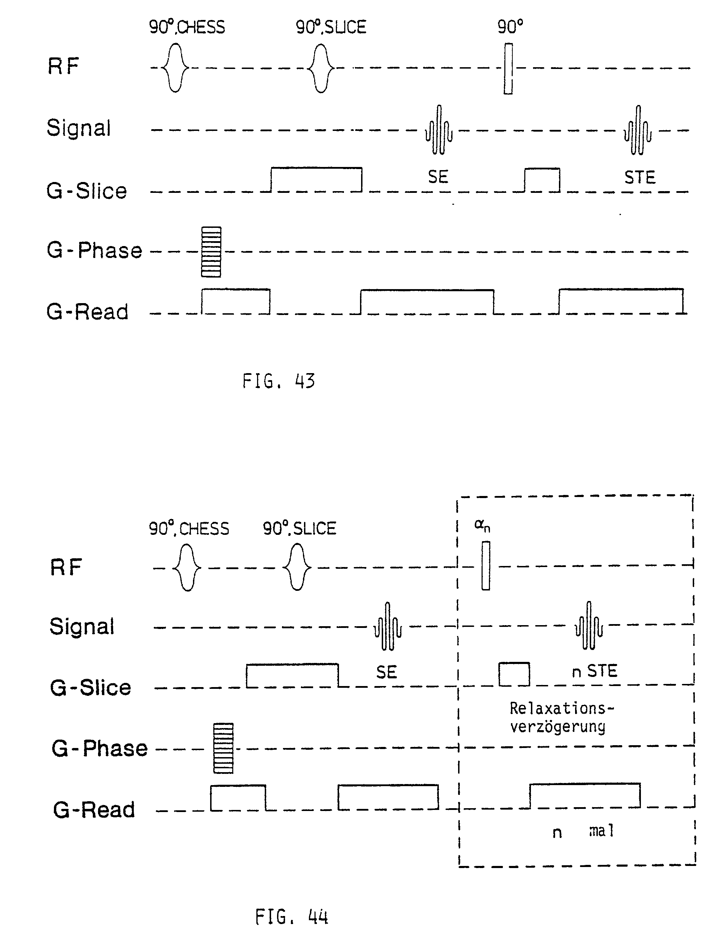

Die Figuren 43 bis 49 betreffen Ausführungsformen zum Erzeugen resonanzlinienselektiver Tomogramme. Insbesondere lassen sich hierdurch die durch unterschiedliche chemische Bindungen verursachten Frequenzverschiebungen erfassen.

Die Aufnahme der NMR-Tomogramme erfolgt auf der Grundlage einzelner Linien eines Kernresonanzspektrums. Bestimmte Ausführungsformen ermöglichen die gleichzeitige Aufnahme mehrerer wählbarer Einlinien-Tomogramme.

Das Ablaufprogramm gemäß Fig. 43 liefert ein Einlinien-Tomogramm und gleichzeitig ein SE-Bild. Der erste Hochfrequenzpuls ist ein linienselektiver Puls, der zweite Puls ein Schichtpuls. Der dritte Puls kann ein nicht-selektiver Puls sein.

Das Ablaufprogramm gemäß Fig. 44 ermöglicht die Erzeugung eines Einlinien-Tomogrammes und eine gleichzeitige T$_1$-Messung bzw. die Erzeugung eines T$_1$-Bildes. Hier wird wieder der dritte Puls in eine Folge von "Bruchteilpulsen" aufgeteilt, wie oben anhand der Figuren 40 und 41 erläutert worden ist.

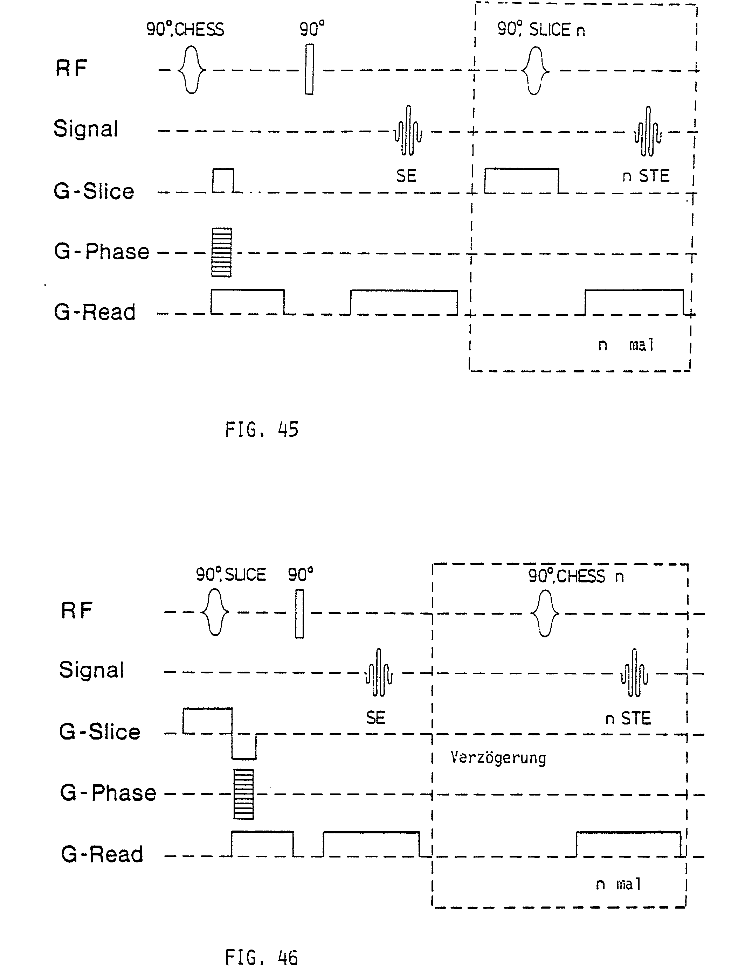

Das Ablaufprogramm gemäß Fig. 45 liefert ein Einlinien-Tomogramm für mehrere Schichten auf der Basis der STE-Signale und gleichzeitig ein Durchleuchtungsbild auf der Basis der SE-Signale.

Das Ablaufprogramm gemäß Fig. 46 liefert mehrere Einlinien-Tomogramme, die durch linienselektive Bruchteilpulse erzeugt und aus den entsprechenden verschiedenen STE-Signalen gewonnen werden und gleichzeitig ein Mischbild, das aus dem SE-Signal gewonnen wird. Man kann also z.B. H$_2$O und Fett in getrennten Einlinien-Tomogrammen und zusammen im Mischbild darstellen.

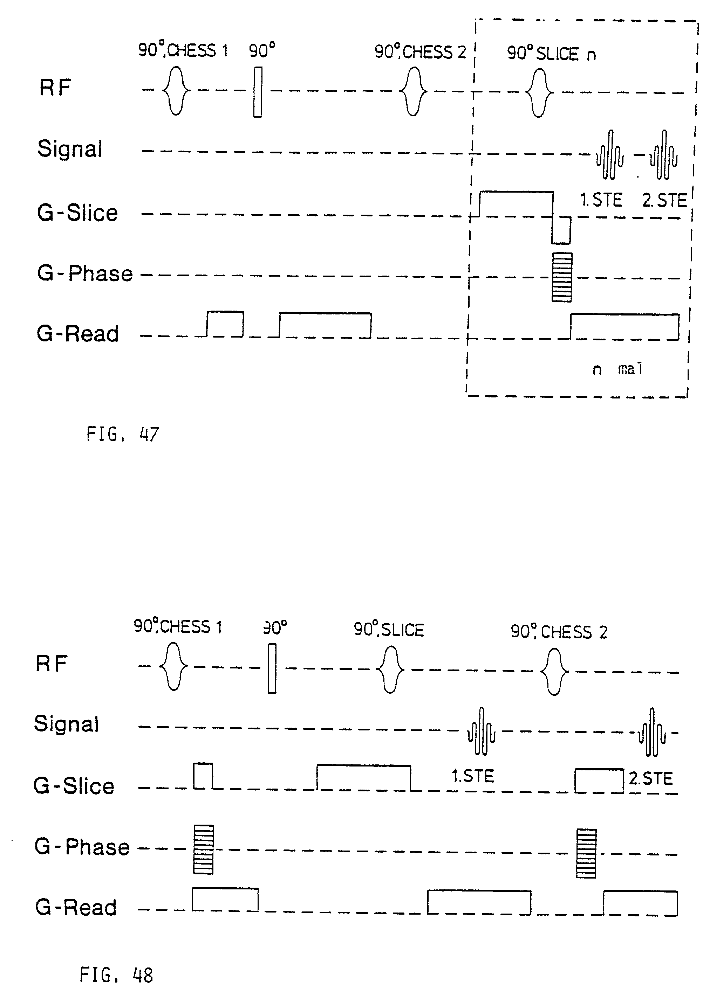

Die Figuren 47 bis 49 zeigen alternative Ablaufprogramme für die Aufnahme von zwei Einlinien-Tomogrammen, z.B. für Fett und Wasser.

Bis jetzt gab es noch keine Möglichkeit ein NMR-Tomogramm auf der Grundlage einer selektiv angeregten Resonanzlinie in einem einzigen Meßzyklus oder Experiment zu erzeugen. Es ist auch keine Möglichkeit bekannt, mit dem in einem einzigen Meßzyklus oder Experiment gleichzeitig mehrere Einlinien-Tomogramme und ein konventionelles Mischbild erzeugt werden können.

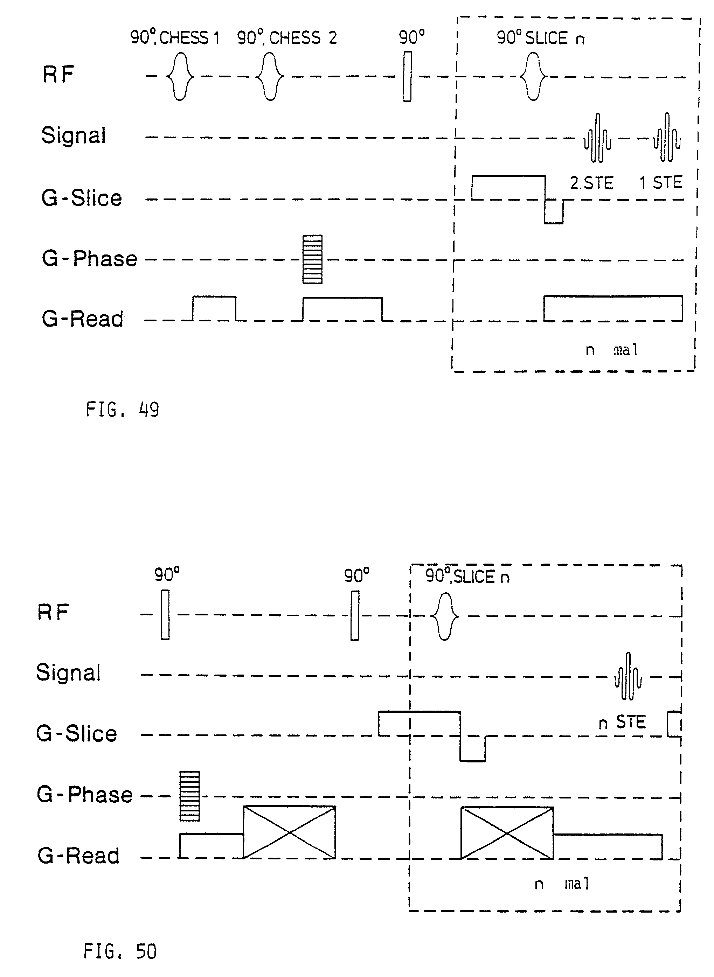

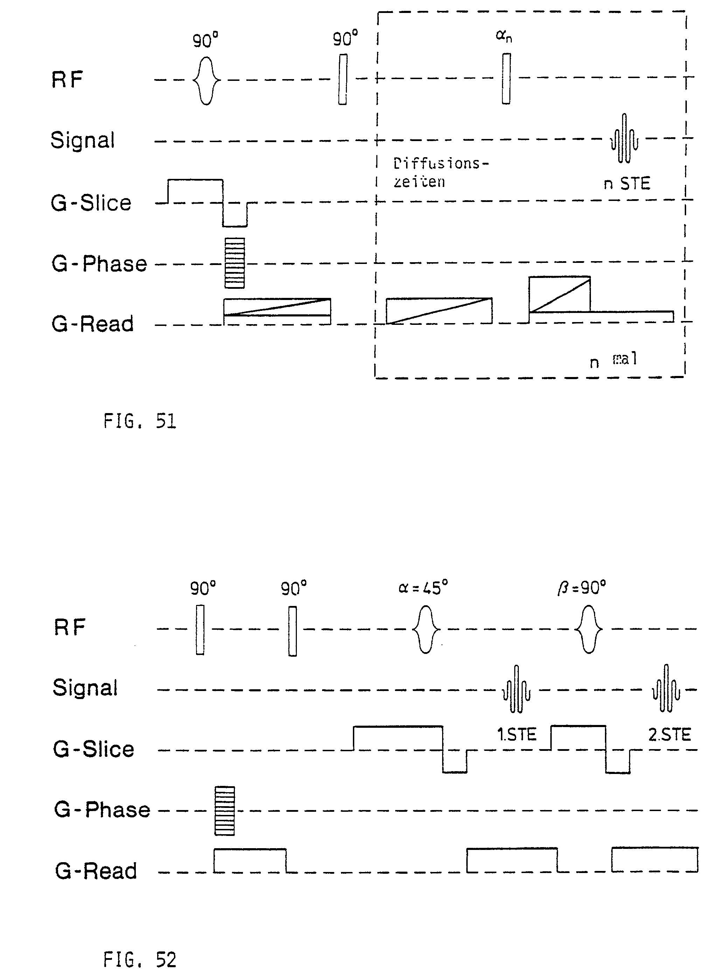

Die Figuren 50 und 51 betreffen Ausführungsformen zur Aufnahme von Diffusions-NMR-Tomogrammen. Bei solchen Tomogrammen bestimmt der lokale Diffusionskoeffizient als wesentlicher kontrastgebender Parameter die Bildintensität. Eine Auswertung mehrerer Bilder unterschiedlicher Diffusions-Wichtungen erlaubt die Auswertung reiner Tomogramme des lokalen Diffusionskoeffizienten. Nicht-selektive Pulse können durch frequenzselektive Pulse ersetzt werden, z.B. für die Bestimmung von Veränderungen des Diffusionskoeffizienten unterschiedlicher Moleküle.

Fig. 50 zeigt ein Ablaufprogramm zum Erzeugen von Mehrschicht-Diffusionsbildern.

Fig. 51 zeigt ein Ablaufprogramm zum Erzeugen einer Serie von Diffusionsbildern mit unterschiedlichen Diffusionszeiten in der Meßzeit eines gewöhnlichen Tomogrammes. Zur Diskriminierung gegen T$_1$-Relaxationseinflüsse sollte zusätzlich eine entsprechende Bildserie gemäß Fig. 40 gemessen werden. Die mit einem Diagonalstrich bezeichneten Abschnitte hoher Amplitude des Lesegradienten (G-Read) sind für die Erzeugung der Diffusionsbilder maßgeblich.

Die Figuren 52 bis 56 betreffen Ablaufprogramme zum Erzeugen von Fluß-NMR-Tomogrammen, d.h. von Tomogrammen zur Bestimmung bzw. Darstellung von Strömungseffekten. Nicht-selektive Pulse können durch frequenzselektive Pulse ersetzt werden.

Fig. 52 zeigt ein Ablaufprogramm zur Flußdarstellung durch ein STE-Differenzbild (1. STE – 2. STE).

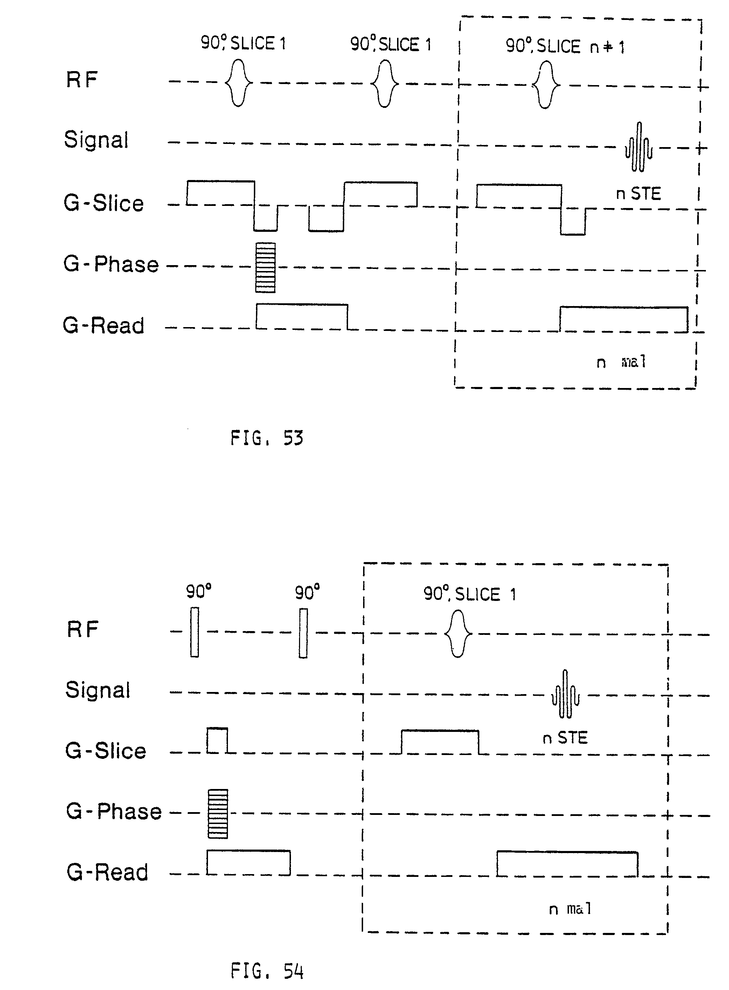

Fig. 53 zeigt ein Ablaufprogramm zum Herstellen von Mehrschicht-Flußtomogrammen, mit denen insbesondere die aus einer Schicht austretende Strömung sichtbar gemacht werden kann. Die Bilder der Zielschichten werden aus den STE-Signalen gewonnen.

Fig. 54 zeigt ein Ablaufprogramm zum Herstellen von Mehrfach-Tomogrammen einer Schicht, mit denen insbesondere die in eine selektierte Schicht eintretende Strömung sichtbar gemacht werden kann. Die betreffende Schicht wird durch den als Schichtimpuls ausgebildeten dritten Impuls weitgehend "ausgeräumt", so daß spätere stimulierte Echos aus dieser Schicht im wesentlichen nur durch angeregte Kerne, die in die Schicht hineingeflossen sind, erzeugt werden können.

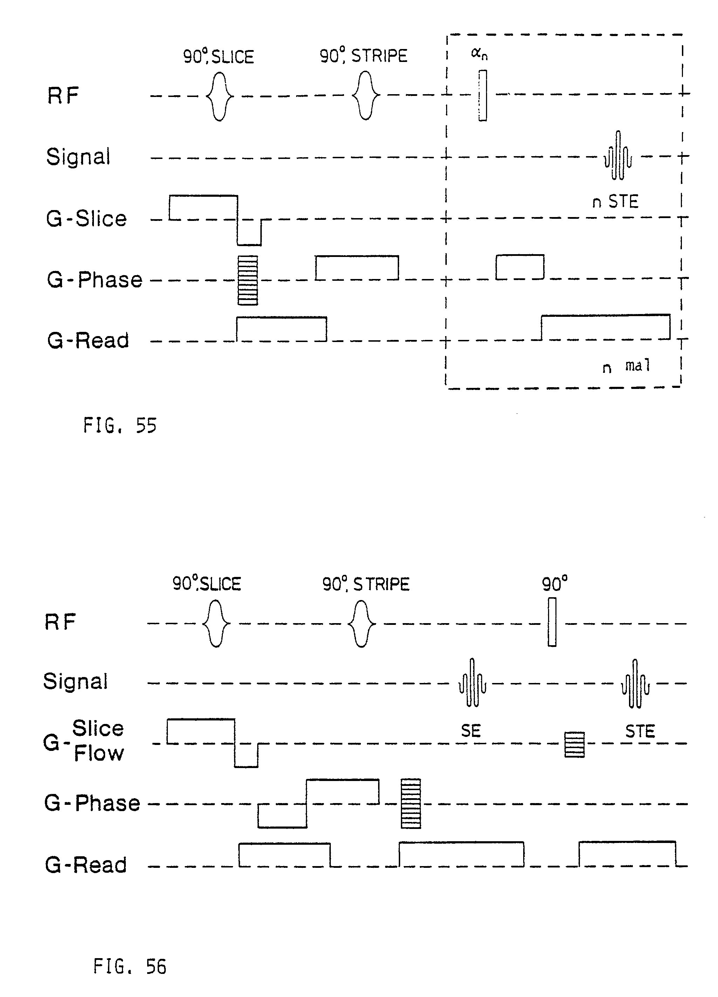

Fig. 55 zeigt ein Ablaufprogramm zum Erzeugen von Mehrfach-Tomogrammen einer Schicht zur Beobachtung der in der Schichtebene verlaufenden Strömung aus einem selektierten, insbesondere streifenförmigen Bereich.

Fig. 56 zeigt ein Ablaufprogramm, das gleichzeitig ein Normalbild (SE-Bild) eines selektierten Bereiches sowie ein entsprechendes 2D-Flußbild (Fluß-Ort-Tomogramm) liefert. Der Bereich kann insbesondere ein Randstreifen der Probe sein.

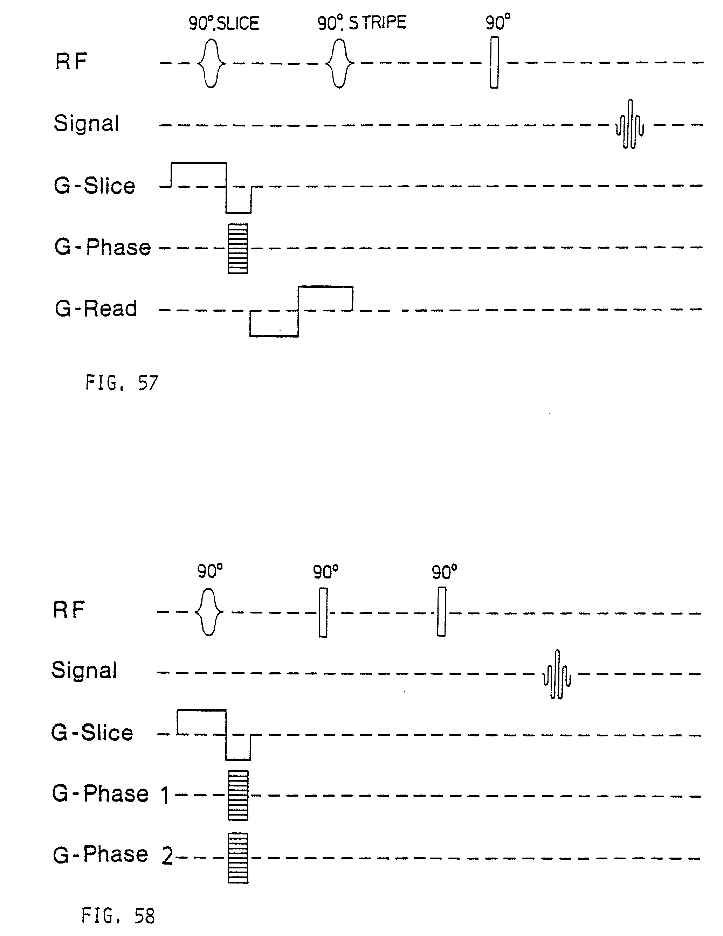

Die Ablaufprogramme gemäß Fig. 57 bis 59 ermöglichen die Aufnahme von NMR-Tomogrammen, die sowohl räumliche als auch spektrale Information darstellen.

Fig. 57 zeigt ein Ablaufprogramm, das ein 2D-Spektrum-Ort-Tomogramm eines selektierten, streifenförmigen Bereiches liefert.

Das Ablaufprogramm gemäß Fig. 58 liefert ein 3D-Tomogramm (Spektrum-Ort-Ort) aus einer Schicht. Das STE-Signal kann wieder durch eine Fourier-Transformation in ein Frequenzspektrum umgesetzt werden.

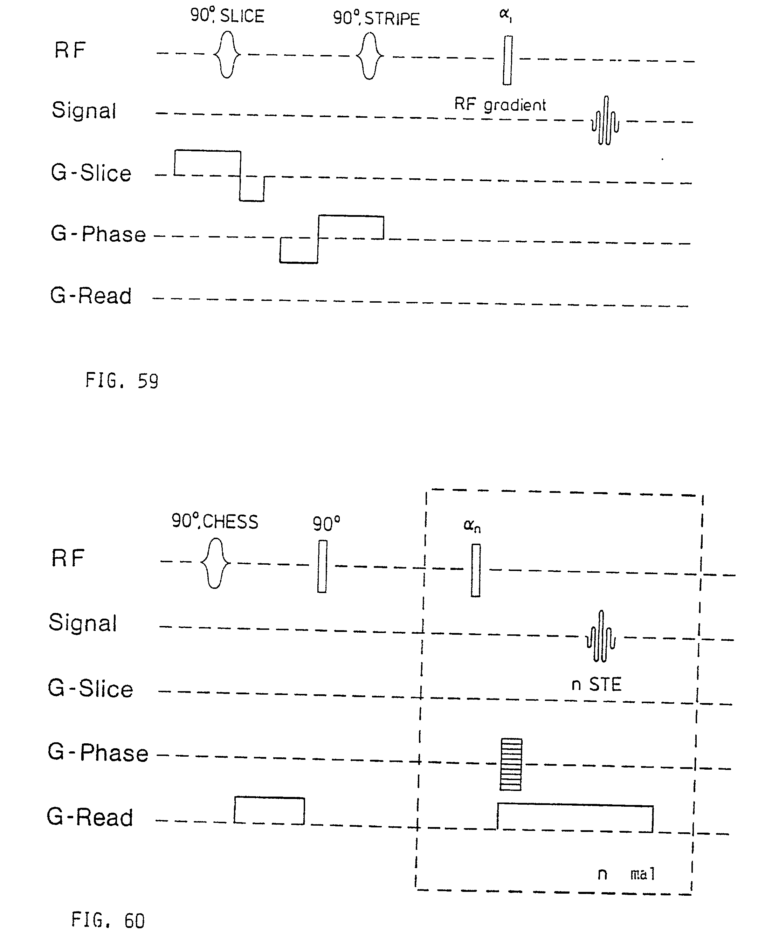

Die Figur 59 zeigt ein Ablaufprogramm zum Erzeugen eines 2D-Tomogrammes (Spektrum-Ort) entsprechend Fig. 57, wobei die Ortscodierung mit Hilfe eines Phasengradienten hier durch einen Hochfrequenzgradienten ersetzt wird ("Rotating Frame Imaging").

Im Gegensatz zu den bisherigen auflösenden Spin-Echo-Verfahren (90-Grad-180-Echoverfahren) gestatten es die mit einer 3-Puls-Sequenz arbeitenden Einrichtungen gemäß der Erfindung das Abklingen von Wirbelströmen während eines Intervalles (z.B. 100 bis 200 ms) abzuwarten, in denen nur $T_1$- und nicht $T_2$-Verluste auftreten. Die $T_1$-Verluste können durch Optimierung der Gradientenanordnungen minimal gehalten werden.

Die Ablaufprogramme gemäß Fig. 60 bis 67 betreffen die Erzeugung sogenannter Ein-Schuß-Tomogramme und ermöglichen die Aufnahme von NMR-Tomogrammen mit einer Meßzeit, die deutlich unter einer Sekunde liegt. Diese Ablaufprogramme eignen sich insbesondere zur Realzeit-Abbildung veränderlicher Vorgänge.

Fig. 60 zeigt ein Ablaufprogramm zur schnellen Durchleuchtungs-Tomographie. Dadurch, daß der erste 90-Grad-Puls ein selektiver, insbesondere ein linienselektiver Puls ist, kann die Verteilung von z.B. Wasser, Fett oder einem Element wie F, Na, P kernspintomographisch dargestellt werden. Bei Leseimpulsen (Bruchteilpulsen) ungenügender Bandbreite ist es zweckmäßig, die Lesegradienten während der Pulsdauer auszuschalten. Die schematische Darstellung des Phasengradienten ist so zu verstehen, daß nach jedem Bruchteilpuls eine andere Gradientenstärke geschaltet wird. Die Reihenfolge des Durchlaufens aller nötigen Gradientenschaltungen kann variiert werden.

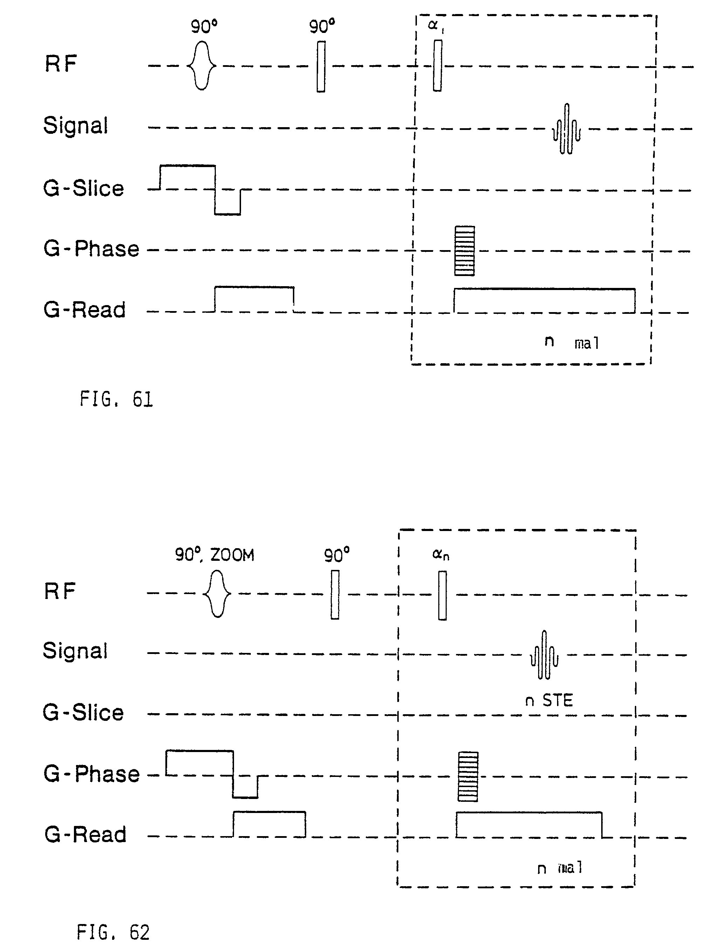

Fig. 61 zeigt ein Ablaufprogramm zur schnellen Sichtbild-Tomographie, bei dem der erste Puls als Schichtpuls genutzt wird.

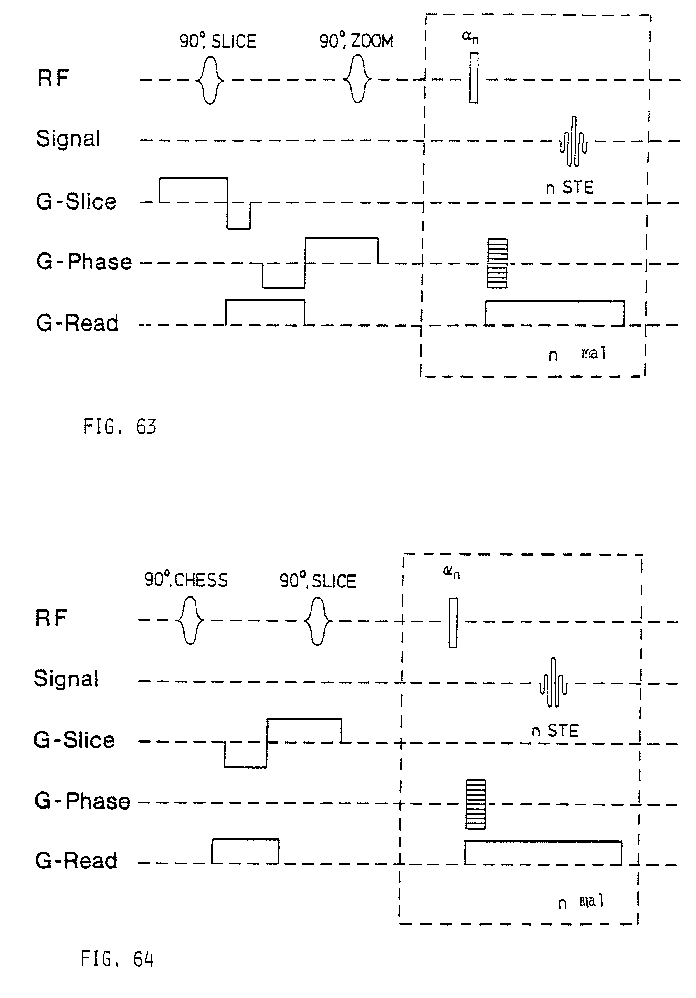

Fig. 62 und 63 sind Zoom-Varianten des Ablaufprogrammes gem. Fig. 60 bzw. 61. Fig. 64 ist eine linienselektive (chemical shift selective) Variante des Ablaufprogrammes gemäß Fig. 61.

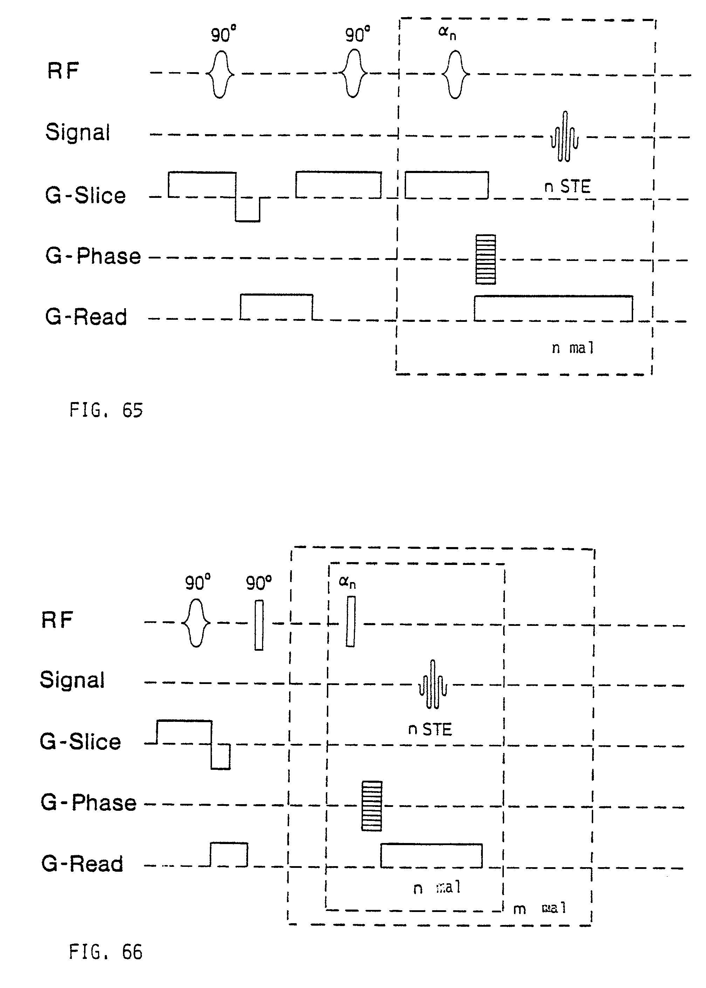

Fig. 65 ist eine Variante des Ablaufprogrammes gemäß Fig. 61 nur mit schichtselektiven Pulsen.

Fig. 66 zeigt eine Mehrfach-Variante des Ablaufprogrammes gemäß Fig. 61 mit $T_1$-Informationen. Während des $T_1$-Abfalles werden mehrere Aufnahmen gemacht, nach Beendigung der Serie kann sofort wieder begonnen werden, so daß sich dieses Ablaufprogramm ebenfalls sehr gut für eine Realzeitabbildung bewegter Strukturen eignet.

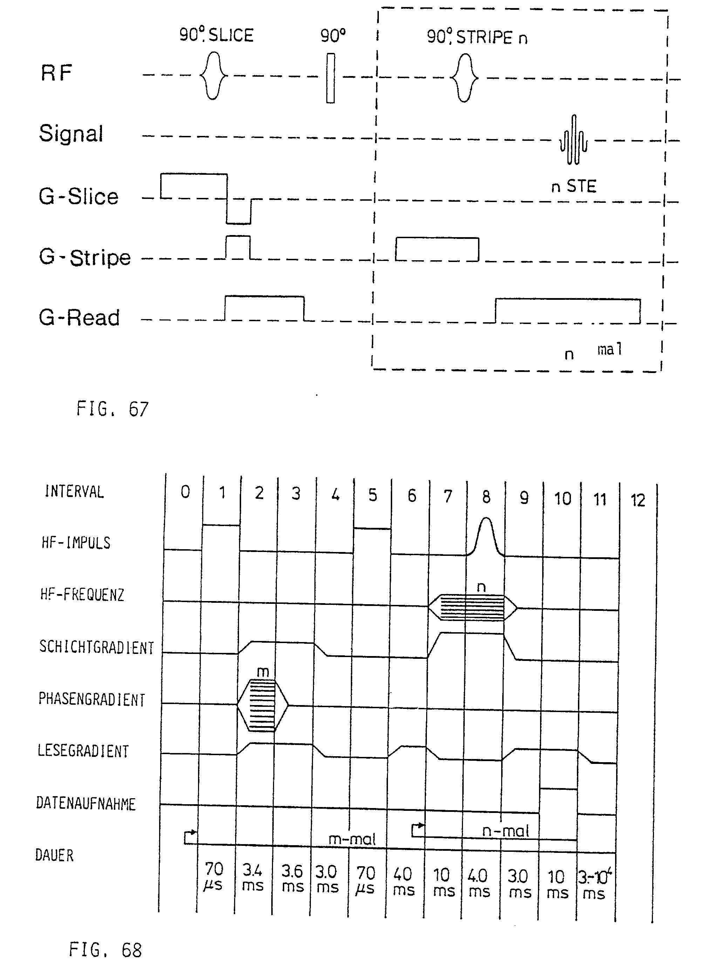

Fig. 67 zeigt ein Ablaufprogramm zur schnellen Schichtbild-Tomographie auf der Grundlage einer Ein-Schuß-Mehrstreifen-Abbildung.

Bei den Ablaufprogrammen gemäß Fig. 60 bis 67 werden die beim Stand der Technik sehr störenden Probleme vermieden, die durch schnelles Schalten der Gradienten sowie durch HF-Absorption auftreten. Darüber hinaus ist die Signalintensität nur mit dem langsamen $T_1$-Abfall gefaltet. Die Rekonstruktion kann mit konventionellen 1D- oder 2D-FT-Algorithmen erfolgen.

Im folgenden werden einige spezielle praktische Ausführungsbeispiele der oben angegebenen Ausführungsbeispiele der Erfindung näher erläutert. Als Kernspinresonanzgerät wurde ein kommerzielles Tomographie/Spektroskopie-System der Firma Bruker (Karlsruhe, Bundesrepublik Deutschland) mit entsprechend eingerichteter Steuereinrichtung verwendet, das einen Magneten mit einer Bohrung von 40 cm Durchmesser und einer Nenn-Feldstärke von 2,3 Tesla (T), entsprechend 100 MHz Protonen-Resonanzfrequenz enthält.

Beispiel 1

Mehrschicht-Aufnahme mit stimulierten Echos

Die im folgenden genauer erläuterten Pulsesequenzen sind in Fig. 68 dargestellt.

Intervall Bemerkung

0 Vor Beginn der Sequenz wird die HF-Frequenz auf die gewünschte Meßfrequenz eingestellt, z.B. auf die genaue Resonanzfrequenz der Wasserprotonen (ca. 100 MHz).

1 Schaltung eines nicht-selektiven HF-Impulses mit rechteckiger Hüllkurve. Bei Verwendung eines Resonatorprobenkopfes (100 MHz, Ø 20 cm) und einer Sendeleistung von 5–8 kW ergeben sich je nach Untersuchungsobjekt Pulslängen von 50–100 Mikrosekunden für einen Flipwinkel von 90 Grad. Bei jedem zweiten Durchlaufen der Sequenz (m verschiedene Phasengradienten!) wird die Phasenlage dieses Pulses um 180 Grad gedreht.

2 Anschalten des Phasengradienten. Dieser Vorgang wird bei Wiederholung der Sequenz mit m verschiedenen Amplituden (hier m = 256) von –0,7 bis +0,7 $10^{-4}$T/cm insgesamt 256mal durchlaufen. Anschalten des Schichtgradienten zur "Refokussierung" aller später geschalteten Schichtgradienten (Intervall 8). Amplitude 0,25 $10^{-4}$T/cm.

Anschalten des Lesegradienten zur Vorbereitung aller in den Intervallen 9 und 10 zur Datenaufnahme geschalteten Lesegradienten; Amplitude 0,45 $10^{-4}$T/cm.

3 Abschalten des Phasengradienten.

4 Abschalten des Schichtgradienten;

Abschalten des Lesegradienten.

5 Wie 1, aber mit konstanter Phasenlage.

6 Anschalten des Lesegradienten zur Dephasierung unerwünschter Signale, Amplitude 0,45 $10^{-4}$ T/cm.

7 Abschalten des Lesegradienten; Anschalten des Schichtgradienten, Amplitude 0,5 $10^{-4}$T/cm.

Setzen der HF-Frequenz für die gewünschte Schnittebene. Bei Wiederholung dieses Teils der Sequenz mit gleichen Lesegradienten werden insgesamt n verschiedene Frequenzen gesetzt (hier n = 7), Frequenzabstände alternierend plus/minus 1kHz bezüglich der im Intervall 0 eingestellten Resonanzfrequenz.

8 "Selektiver" HF-Impuls mit einem Flipwinkel von 90 Grad und Gauß-förmiger Hüllkurve. Die Halbwertsbreite des Frequenzspektrums des Pulses beträgt ca. 700 Hz. Die Phasenlage des Pulses ist identisch mit der des Pulses in Intervall 1 und variiert synchron.

9 Zurücksetzen der HF-Frequenz auf den ursprünglichen Wert vor Aufnahme der Daten; Abschalten des Schichtgradienten; Anschalten des Lesegradienten Amplitude 0,45 $10^{-4}$T/cm.

10 Aufnahme von je 256 "realen" und imaginären" Daten durch Quadraturdetektion mit einer spektralen Weite von 25 kHz (Abtastzeit 20 Mikrosekunden). Nach Beendigung der Datenaufnahme springt die Sequenz zurück an den Beginn von Intervall 7. Dieser Zyklus für die Aufnahme der Daten aus mehreren Schnittebenen wird n-mal durchlaufen (hier n = 7).

11 Abschalten des Lesegradienten.

Nach Beendigung der Sequenz, d.h. nach Intervall 11, wird die Sequenz m-mal mit inkrementierten Amplituden des Phasengradienten wiederholt. Sie springt dazu zurück an den Beginn von Intervall 1. Eine Akkumulation von Messungen mit gleichen Phasengradienten ist möglich, wurde experimentell aber nicht für nötig erachtet, so daß sich die Gesamtmeßzeit ergibt als m-mal die Summe der Intervalldauern von Intervall 1 bis 11.

Die Meßzeit für eine Mehrschichtaufnahme mit sieben Schichten, Schichtdicke jeweils 3 bis 4 mm, beträgt etwa 4 Minuten.

Beispiel 2: Multiple CHESS-Imaging

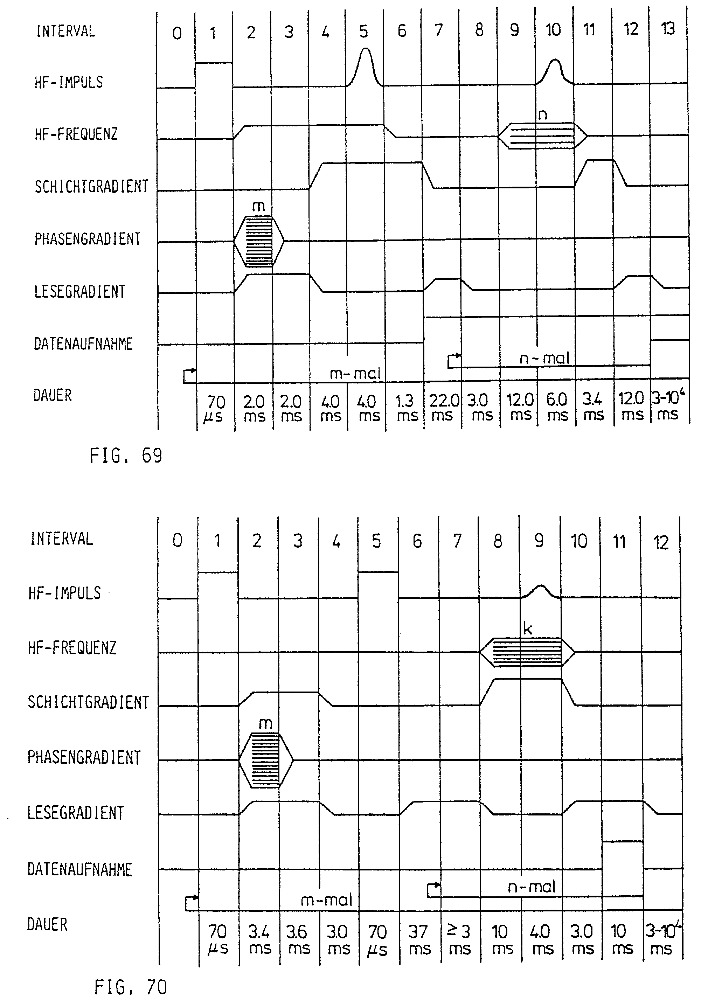

Aufnahme eines Summenbildes und mehrerer CHESS-STE-Bilder (CHESS = chemical shift selective) aus einer Schicht. Die im folgenden genauer erläuterten Pulssequenzen sind in Fig. 69 dargestellt.

Intervall Bemerkung

0 Vor Beginn der Messung wird die HF-Frequenz auf eine beliebige gewünschte Meßfrequenz eingestellt, z.B. auf die Resonanzfrequenz der Wasserprotonen.

1 Schaltung eines nicht-selektiven HF-Pulses mit rechteckiger Hüllkurve bei Verwendung eines Resonatorprobenkopfes (100 MHz, 20 cm Durchmesser) und einer HF-Sendeleistung von etwa 5 kW ergeben sich, abhängig vom Untersuchungsobjekt, Pulslängen von 50 bis 100 Mikrosekunden für einen Flipwinkel von 90 Grad. Bei jedem zweiten Durchlauf der Gesamtsequenz mit m verschiedenen Phasengradienten kann die Phasenlage des Pulses um 180 Grad gedreht werden.

2 Umschalten der HF-Frequenz für die gewünschte Schnittebene. Anschalten des Phasengradienten. Dieser Vorgang wird bei Wiederholung der Sequenz mit m verschiedenen Amplituden des Phasengradienten (hier m = 256) von -0,7 bis +0,7 $10^{-4}$ T/cm insgesamt 256mal durchlaufen.

Anschalten des Lesegradienten zur Vor-"Refokussierung" aller später in den Intervallen 7 und 12 geschalteten Lesegradienten zur Datenaufnahme. Die Gradientenamplitude ist hier 0,64 $10^{-4}$T/cm.

3 Abschalten des Phasengradienten; Der Lesegradient bleibt weiter angeschaltet; Die HF-Frequenz bleibt weiter auf der Frequenz der Bildebene.

4 Abschalten des Lesegradienten. Anschalten des Schichtgradienten. zur Vor-"Refokussierung" des Schichtgradienten. Die Amplitude des Schichtgradienten ist 0,51 $10^{-4}$ T/cm.

5 Selektiver HF-Impuls mit Flipwinkel von 90 Grad und Gauß-förmiger Hüllkurve. Die Halbwertsbreite des Frequenzspektrums des Pulses beträgt etwa 700 Hz. Im Zusammenwirken mit dem Schichtgradienten ergibt dies eine Schichtdicke von ca. 3-4 mm.

6 Der Schichtgradient bleibt weiter angeschaltet zur Refokussierung für die Datenaufnahme des Spinechos in Intervall 7. Die HF-Frequenz wird auf die gewünschte Rekonstruktions-Frequenz geschaltet.

7 Abschalten des Schichtgradienten und Anschalten des Lesegradienten mit der Amplitude 0,46 $10^{-4}$T/cm. Die Datenaufnahme wird zur Acquisition des Spinechos sowie der stimulierten Echos angeschaltet. Zur Berechnung des Summenbildes und der CHESS-Bilder werden jeweils 256 "reale" und "imaginäre" Datenpunkte bei "Quadraturdetektion" mit einer spektralen Breite von 25 kHz (Abtastzeit 20 Mikrosekunden), zentriert um die jeweiligen Echo-Maxima, aus dem gesamten Datensatz selektiert.

8 Abschalten des Lesegradienten.

9 Umsetzen der HF-Frequenz auf die Resonanz-Frequenz einer zu selektierenden Substanz, z.B. die Fettprotonen. Bei n-fachem Durchlaufen der Intervalle 8-12 wird die Frequenz auf n verschiedene NMR-Resonanzfrequenzen gesetzt (hier ist n = 2 für die Resonanzfrequenzen der Wasser- und Fettprotonen).

10 Selektiver HF-Impuls mit einem Flipwinkel von 90 Grad und Gauß-förmiger Hüllkurve. Die Halbwertsbreite des Frequenz-Spektrums des Pulses beträgt etwa 200 Hz. Der HF-Impuls regt nur eine Linie des NMR-Spektrums an. Die Phasenlage des Pulses wird synchron mit der des Pulses in Intervall 1 geschaltet.

11 Anschalten des Schichtgradienten mit einer Amplitude von 0,72 $10^{-4}$ T/cm zum Refokussieren des Schichtgradienten aus den Intervallen 4 und 5. Zurücksetzen der HF-Frequenz auf die Frequenz der Bildebene zur Datenaufnahme.

12 Abschalten des Schichtgradienten; Anschalten des Lesegradienten, Amplitude 0,46 $10^{-4}$T/cm. Datenaufnahme eines NMR-frequenzselektiven (CHESS) stimulierten Echo-Signales. Es werden 256 "reale" und "imaginäre" Datenpunkte bei "Quadraturdetektion" mit spektraler Breite von 25 kHz (Abtastzeit 20 Mikrosekunden) aufgenommen.
Anschließend werden die Intervalle 8-12 n-mal durchlaufen zur Aufnahme von n (hier n = 2) frequenzselektiven stimulierten Echo-Bildern.

13 Abschalten des Lesegradienten und der Datenaufnahme.

Nach Beendigung der Gesamtsequenz, d.h. nach Intervall 13, wird die Sequenz m-mal mit inkrementierten Amplituden des Phasengradienten wiederholt. Die Sequenz springt jedesmal zurück zu Intervall 1. Eine Akkumulation von Messungen mit gleichen Phasengradienten zur Verbesserung des Signal/Rausch-Verhältnisses ist möglich, aber experimentell nicht nötig gewesen.

Die Gesamtmeßzeit des Summenbildes, sowie n verschiedener CHESS-Bilder ergibt sich als m-mal die Summe der Intervalldauern von Intervall 1 bis 13 einschließlich.

Die Meßzeit für ein Mischbild, Wasserbild und Fettbild mit einer Schichtdicke von jeweils 3 bis 4 mm, beträgt etwa 4 Minuten.

Beispiel 3

Mehrbild-Aufnahmen der $T_1$-Relaxationskurve mit stimulien Echos

Die im folgenden genauer erläuterten Pulssequenzen sind in Fig. 70 dargestellt.

Intervall Bemerkung

0 Vor Beginn der Sequenz wird die HF-Frequenz auf die gewünschte Meßfrequenz eingestellt, z.B. auf die genaue Resonanzfrequenz der Wasserprotonen.

1 Schaltung eines nicht-selektiven HF-Impulses mit rechteckiger Hüllkurve. Bei Verwendung eines Resonatorprobenkopfes (100 MHz, ⌀ 20 cm) und einer Sendeleistung von 5-8 kW ergeben sich je nach Untersuchungsobjekt Pulslängen von 50-100 Mikrosekunden für einen Flipwinkel von 90 Grad. Bei jedem zweiten Durchlaufen der Sequenz (m verschiedene Phasengradienten!) wird die Phasenlage dieses Pulses um 180 Grad gedreht.

2 Anschalten des Phasengradienten. Dieser Vorgang wird bei Wiederholung der Sequenz mit m verschiedenen Amplituden (hier m = 256) von -0,7 bis +0,7 $10^{-4}$T/cm insgesamt 256mal durchlaufen.
Anschalten des Schichtgradienten zur "Refokussierung" aller später geschalteten Schichtgradienten (Intervall 9). Amplitude 0,25 $10^{-4}$T/cm.
Anschalten des Lesegradienten zur Vorbereitung aller in den Intervallen 10 und 11 zur Datenaufnahme geschalteten Lesegradienten. Amplitude 0,45 $10^{-4}$T/cm.

3 Abschalten des Phasengradienten.

4 Abschalten des Schichtgradienten; Abschalten des Lesegradienten.

5 wie 1, aber mit konstanter Phasenlage.

6 Anschalten des Lesegradienten zur Dephasierung unerwünschter Signale. Amplitude 0,45 $10^{-4}$T/cm

7 Variable Zeit zur Einstellung der Relaxationsintervalle (Dauer der Intervalle 7-11, wobei die Intervalle 8-11 zusammen 27 ms betragen). Für eine Mehrschichtmessung (5 Schichten, k=5, 5 Relaxationsintervalle n=25) aus insgesamt 25 Enzelbildern wurde eine Dauer von 3 ms gewählt. Für eine Einschichtmessung an der menschlichen Hand (k=1, n=16) aus 16 Einzelbildern wurde eine Dauer von 23 ms gewählt.

8 Abschalten des Lesegradienten; Anschalten des Schichtgradienten mit einer Amplitude von 0,5 $10^{-4}$T/cm.
Setzen der HF-Frequenz für die gewünschte Schnittebene. Bei Wiederholung dieses Teiles der Sequenz (insgesamt n-mal) werden k verschiedene Frequenzen gesetzt (hier k = 1).

9 "Selektiver" HF-Impuls mit Gauß-förmiger Hüllkurve. Die Halbwertsbreite des Frequenzspektrums des Pulses beträgt ca. 700 Hz. Die Phasenlage des Pulses ist identisch mit der des Pulses in Intervall 1 und variiert synchron. Die Flipwinkel des n-mal wiederholten HF-Impulses wurden gleich eingestellt. Sie betrugen für eine 16-Bild-Messung kleiner oder gleich 9 Grad und für eine 5-Schichtmessung mit jeweils 5 Bildern kleiner oder gleich 15 Grad.

10 Zurücksetzen der HF-Frequenz auf den ursprünglichen Wert vor Aufnahme der Daten; Abschalten des Schichtgradienten; Anschalten des Lesegradienten. Amplitude 0,45 $10^{-4}$T/cm.

11 Aufnahme von je 256 "realen" und "imaginären" Daten bei Quadraturdetektion mit einer spektralen Weite von 25 kHz (Abtastzeit 20 Mikrosekunden). Nach Beendigung der Datenaufnahme springt die Sequenz zurück an den Beginn von Intervall 7. Dieser Zyklus für die Aufnahme von Daten aus mehreren Schnittebenen und/oder von mehreren Bildern mit unterschiedlichen Relaxationsintervallen wird n-mal durchlaufen (hier n=16).

12 Abschalten des Lesegradienten.

Nach Beendigung der Sequenz, d.h. nach Intervall 12, wird die Sequenz m-mal mt inkrementierten Amplituden des Phasengradienten wiederholt. Sie springt dazu zurück an den Beginn von Intervall 1. Eine Akkumulation von Messungen mit gleichen Phasengradienten ist möglich, wurde experimentell aber nicht für nötig erachtet, so daß sich die Geamtmeßzeit ergibt als m-mal die Summe der Intervalldauern von Intervall 1 bis 12.

Beispiel 4

Schnelle Tomographie mit stimulierten Echos (64 x 128-Bild)

Die im folgenden genauer erläuterten Pulssequenzen sind in Fig. 71 dargestellt.

Intervall Bemerkung

0 Vor Beginn der Sequenz wird die HF-Frequenz auf die gewünschte Meßfrequenz eingestellt, z.B. auf die genaue Resonanzfrequenz der Wasserprotonen.

1 Anschalten des Schichtgradienten mit der Amplitude $0{,}5 \cdot 10^{-4}$T/cm;
Setzen der HF-Frequenz für die gewünschte Schnittebene.

2 "Selektiver" HF-Impuls mit einem Flipwinkel von 90 Grad und Gauß-förmiger Hüllkurve. Die Halbwertsbreite des Frequenzspektrums des Pulses beträgt ca. 2 kHz.

3 Zurücksetzen der HF-Frequenz auf den ursprünglichen Wert vor Aufnahme der Daten;
Umschalten des Schichtgradienten auf die Amplitude $-0{,}31 \cdot 10^{-4}$T/cm;
Anschalten des Lesegradienten, Amplitude $0{,}45 \cdot 10^{-4}$T/cm.

4 Abschalten des Schichtgradienten;
Abschalten des Lesegradienten.

5 Schaltung eines nicht-selektiven HF-Impulses mit rechteckiger Hüllkurve. Bei Verwendung eines Resonatorprobenkopfes (100 MHz, ⌀ 20 cm) und einer Sendeleistung von 5-8 kW ergeben sich je nach Untersuchungsobjekt Pulslängen von 50-100 Mikrosekunden für einen Flipwinkel von 90 Grad.

6 Anschalten des Phasengradienten. Dieser Vorgang wird bei Wiederholung der Intervalle 6-9 mit m verschiedenen Amplituden (hier m = 4) von $-0{,}43$ bis $-0{,}37 \cdot 10^{-4}$T/cm insgesamt 4-mal durchlaufen;
Anschalten des Lesegradienten, Amplitude $0{,}35 \cdot 10^{-4}$T/cm.
Das wiederholte Durchlaufen der Intervalle 6 bis 9 dient zur Dephasierung des unerwünschten Spin-Echos sowie zur Einstellung eines Gleichgewichtszustandes für die notwendge schnelle Schaltung der beiden Gradienten.

7 Abschalten des Phasengradienten;
Weiterschalten des Lesegradienten Amplitude $0{,}45 \cdot 10^{-4}$T/cm.

8 Wartezeit, deren Dauer der in Intervall 13 zu erfolgenden Datenaufnahme entspricht.

9 Abschalten des Lesegradienten.
Nach Beendigung von Intervall 9 springt die Sequenz zurück an den Beginn von Intervall 6 (hier n = 4).

10 wie 5, aber mit kürzeren Pulslängen, die Pulsen mit Flipwinkeln ä 90 Grad entsprechen. Beim m-maligen Durchlaufen der Intervalle 10-14 werden die Pulslängen (Intervall 10) gleich gewählt (hier m = 64). Dieser Vorgang führt zur Aufnahme von 64 stimulierten Echos mit unterschiedlichen Phasencodierungen, aus denen sich ein 64 x 128 - Bild berechnen läßt.

11 Wie 6, aber mit m inkrementierten Amplituden von $-0{,}37 \cdot 10^{-4}$T/cm bis $+0{,}37 \cdot 10^{-4}$T/cm (hier m = 64).

12 Wie 7.

13 Aufnahme von je 128 "realen" und "imaginären" Daten durch Quadraturdetektion mit einer spektralen Weite von 25 kHz (Abtastzeit 20 Mikrosekunden).

14 Abschalten des Lesegradienten.

Nach Beendigung von Intervall 14 springt die Sequenz zurück an den Beginn von Intervall 10. Dieser Zyklus für die Aufnahme der m unterschiedlich phasencodierten Echos wird m-fach durchlaufen (hier m = 64). Die Messung der Daten dauert somit m-mal die Summe der Intervalle 10-14, die Dauer der Gesamtsequenz enthält zusätzlich die Summe der Intervalle 1 bis 5, sowie n-mal die Summe der Intervalle 6 bis 9.

**Patentansprüche**

1. Einrichtung zur ortsaufgelösten Untersuchung eines Objekts mittels magnetischer Resonanz von Spinmomenten, mit
– einer Vorrichtung (16, 24) zum Erzeugen eines konstanten Magnetfeldes im Objekt,
– Vorrichtungen (18, 20, 22, 28) zum Erzeugen einer variablen Kombination von drei im wesentlichen aufeinander senkrecht stehenden Gradienten-Magnetfeldern im Objekt,
– einer Vorrichtung (24, 30) zum Beaufschlagen des Objekts mit einer Folge von Hochfrequenzpulsen, die drei aufeinanderfolgende Pulse mit Flipwinkeln ungleich ⌈mπ⌉ enthält,
– einer Vorrichtung zur Erfassung von Signalen entsprechend einer magnetischen Resonanz von Spinmomenten im Objekt, und
– einer Steuereinrichtung (14) für die genannten Vorrichtungen (16, 24; 18, 20, 22, 28; 24, 30), dadurch gekennzeichnet, daß die Steuereinrichtung (14) für eine Steuerung der genannten Vorrichtungen (16, 24; 18, 20, 22, 28; 24, 30) mit einem Ablaufprogramm ausgebildet ist, bei dem
– der Abstand ($\tau$) zwischen dem ersten und dem zweiten Puls größer als $T_{2eff}$ und kleiner als $5T_2$ ist,
– der Abstand ($T-\tau$) zwischen dem zweiten und dem dritten Puls größer als $T_{2eff}$ und kleiner als $5T_1$, ist, wobei
m eine ganze Zahl,
$T_1$ die Spin-Gitter-Relaxationszeit,
$T_2$ die Spin-Spin-Relaxationszeit und
$T_{2eff}$ die effektive Spin-Spin-Relaxationszeit
der zu bestimmenden Spins im Objekt sind,
– mindestens eines der Gradientenfelder zwischen dem ersten und/oder zweiten Puls und/oder dem zweiten und dritten Puls und/oder nach dem dritten Puls umgeschaltet wird,
– mindestens einer der Pulse ein frequenzselektiver Puls ist, und
– mindestens ein durch den dritten Puls stimuliertes Echosignal erfaßt wird.

2. Einrichtung nach Anspruch 1, dadurch gekennzeichnet, daß $\tau$ kleiner als $2T_2$ ist.

3. Einrichtung nach Anspruch 1, dadurch gekennzeichnet, daß ($T-\tau$) kleiner als $3T_2$ ist.

4. Einrichtung nach Anspruch 1, dadurch gekennzeichnet, daß der frequenzselektive Puls durch eine Folge von getrennten Teil- oder Einzelpulsen gebildet wird, die die geforderte Frequenzselektivität ergibt.

5. Einrichtung nach Anspruch 4, dadurch gekennzeichnet, daß mindestens zwei der Einzelpulse unterschiedliche Trägerfrequenzen enthalten.

6. Einrichtung nach Anspruch 4, dadurch gekennzeichnet, daß die Einzelpulse gleiche Trägerfrequenzen enthalten.

7. Einrichtung nach Anspruch 6, dadurch gekennzeichnet, daß die Einzelpulse nicht-selektive sog. "harte" Pulse sind, d.h. eine im wesentlichen rechteckige Hüllkurve, eine möglichst kurze Dauer und eine möglichst hohe Amplitude haben und für sich selbst nicht selektiv sind.

8. Einrichtung nach Anspruch 7, dadurch gekennzeichnet, daß der mindestens ein frequenzselektiver Puls ein frequenzmodulierter Puls ist.

9. Einrichtung nach einem der Ansprüche 1 bis 8, dadurch gekennzeichnet, daß der erste Puls ein ⌈90 Grad⌉–Puls (+/–10%) ist.

10. Einrichtung nach einem der Ansprüche 1 bis 9, dadurch gekennzeichnet, daß der zweite Puls ein ⌈90 Grad⌉–Puls (+/–50%) ist.

11. Einrichtung nach einem der Ansprüche 1 bis 10, dadurch gekennzeichnet, daß der dritte Puls ein ⌈90 Grad⌉–Puls (+/–50%) ist.

12. Einrichtung nach einem der vorhergehenden Ansprüche, dadurch gekennzeichnet, daß zumindest der erste und der zweite Puls im wesentlichen 90-Grad-Pulse sind.

13. Einrichtung nach einem der vorhergehenden Ansprüche, dadurch gekennzeichnet, daß der dritte Puls ein Puls entsprechend einem Bruchteil des angegebenen Flipwinkels ist, daß auf den dritten Puls mindestens ein weiterer "Bruchteilpuls" in einem Abstand, der größer als der Abstand zwischen dem ersten und dem zweiten Puls ist, folgt und daß jedes stimulierte Echo, das auf einen der weiteren Pulse folgt, erfaßt wird.

14. Einrichtung nach Anspruch 13, dadurch gekennzeichnet, daß der Flipwinkel jedes Bruchteilimpulses kleiner als 15 Grad, vorzugsweise kleiner als 10 Grad oder kleiner als 5 Grad ist.

15. Einrichtung nach Anspruch 13 oder 14, dadurch gekennzeichnet, daß der Abstand jedes Bruchteilpulses vom vorangehenden Puls größer als $2\tau$ ist.

16. Einrichtung nach Anspruch 13, 14 oder 15, dadurch gekennzeichnet, daß der Flipwinkel jedes weiteren Pulses größer als der Flipwinkel jedes vorangehenden Pulses ist.

17. Einrichtung nach einem der vorhergehenden Ansprüche, dadurch gekennzeichnet, daß der erste Puls ein Schichtpuls ist.

18. Einrichtung nach einem der Ansprüche 1 bis 17, dadurch gekennzeichnet, daß der zweite Puls ein Schichtpuls ist.

19. Einrichtung nach einem der Ansprüche 1 bis 18, dadurch gekennzeichnet, daß der dritte Puls ein Schichtpuls ist.

20. Einrichtung nach Anspruch 17, 18 oder 19, dadurch gekennzeichnet, daß die restlichen der drei Pulse nichtselektive Pulse sind.

21. Einrichtung nach einem der Ansprüche 1 bis 15, dadurch gekennzeichnet, daß einer der Pulse ein Schichtpuls und ein weiterer der Pulse ein Ausschnitt- d.h. ein sog. Zoom-Puls ist.

22. Einrichtung nach einem der Ansprüche 1 bis 20, dadurch gekennzeichnet, daß mindestens einer der Pulse ein resonanzlinienselektiver Puls ist.

23. Einrichtung nach einem der Ansprüche 1 bis 16, dadurch gekennzeichnet, daß der erste Puls ein resonanzlinienselektiver Puls ist.

24. Einrichtung nach einem der Ansprüche 1 bis 16, dadurch gekennzeichnet, daß der erste Puls ein Schichtpuls ist.

25. Einrichtung nach einem der Ansprüche 1 bis 16, dadurch gekennzeichnet, daß der erste Puls ein Ausschnitts- oder Zoom-Puls ist.

26. Einrichtung nach einem der Ansprüche 23, 24 oder 25, dadurch gekennzeichnet, daß der zweite Puls ein nicht-selektiver sog. "harter" Puls ist.

27. Einrichtung nach Anspruch 23, 24 oder 25, dadurch gekennzeichnet, daß der zweite Puls ein Schichtpuls ist.

28. Einrichtung nach einem der Ansprüche 1 bis 26, dadurch gekennzeichnet, daß die Steuereinrichtung (14) die Erzeugung und Erfassung von stimulierten Echosignalen mit anderen Verfahren kombiniert.

29. Einrichtung nach Anspruch 28, dadurch gekennzeichnet, daß die Steuereinrichtung (14) die Erzeugung und Erfassung der stimulierten Echosignale mit Spin-Echo-Tomographie-Verfahren · durch Hinzufügen von 180-Grad-Pulsen kombiniert.

**Claims**

1. Arrangement for the spatially resolved investigation of a sample by means of magnetic resonance of spin moments, comprising
- a device (16, 24) for producing a constant magnetic field in the sample,
- devices (18, 20, 22, 28) for producing in the sample a variable combination of three gradient magnetic fields situated essentially perpendicularly to one another,
- a device (24, 30) for subjecting the sample to a sequence of high frequency pulses which contains three successive pulses with flip angles unequal ⌈mπ⌉,
- a device for detecting signals corresponding to a magnetic resonance of spin moments in the sample, and
- a control arrangement (14) for the said devices (16, 24; 18, 20, 22, 28; 24, 30), characterized in that the control arrangement (14) for controlling the said devices (16, 24; 18, 20, 22, 28; 24, 30) is provided with an operating cycle in which
- the interval ($\tau$) between the first and the second pulse is greater than $T_{2eff}$ and smaller than $5T_2$,
- the interval ($T-\tau$) between the second and the third pulse is greater than $T_{2eff}$ and smaller than $5T_1$, in which
m is an integer,
$T_1$ is the spin-lattice relaxation time,
   $T_2$ is the spin-spin relaxation time
   $T_{2eff}$ is the effective spin-spin relaxation time of the spins to be determined in the sample,
- at least one of the gradient fields is reversed, between the first and/or the second pulse and/or the second and third pulse and/or after the third pulse,
- at least one of the pulses is a frequency selective pulse, and
- at least one echo signal stimulated by the third pulse is detected.

2. Arrangement according to claim 1, characterized in that $\tau$ is smaller than $2T_2$.

3. Arrangement according to claim 1, characterized in that $(T-\tau)$ is smaller than $3T_2$.

4. Arrangement according to claim 1, characterized in that the frequency selective pulse is formed by a sequence of separate sub or individual pulses, which results in the required frequency selectivity.

5. Arrangement according to claim 4, characterized in that at least two of the individual pulses contain different carrier frequencies.

6. Arrangement according to claim 4, characterized in that the individual pulses contain the same carrier frequencies.

7. Arrangement according to claim 6, characterized in that the individual pulses are non-selective so-called "hard" pulses, i.e. which have essentially a rectangular envelope curve, as far as possible a short duration, and as far as possible of high amplitude, and are not selective in themselves.

8. Arrangement according to claim 7, characterized in that at least one frequency selective pulse is a frequency modulated pulse.

9. Arrangement according to one of the claims 1 to 8, characterized in that the first pulse is a ⌈90 degree⌉–pulse (+/–10%).

10. Arrangement according to one of the claims 1 to 9, characterized in that the second pulse is a ⌈90 degree⌉–pulse (+/–50%).

11. Arrangement according to one of the claims 1 to 10, characterized in that the third pulse is a ⌈90 degree⌉–pulse (+/–50%).

12. Arrangement according to one of the preceding claims, characterized in that at least the first and the second pulse are essentially 90 degree pulses.

13. Arrangement according to one of the preceding claims, characterized in that the third pulse is a pulse corresponding to a fraction of the flip angle stated, that the third pulse is followed by at least one additional "fractional pulse" at an interval which is greater than the interval between the first and the second pulse, and that each stimulated echo which follows one of the additional pulses is detected.

14. Arrangement according to claim 13, characterized in that the flip angle of each fractional pulse is smaller than 15 degrees, preferably smaller than 10 degrees or smaller than 5 degrees.

15. Arrangement according to claim 13 or 14, characterized in that the interval of each fractional pulse from preceding pulse is greater than $2\tau$.

16. Arrangement according to claim 13, 14 or 15, characterized in that the flip angle of each additional pulse is greater than the flip angle of each preceding pulse.

17. Arrangement according to one of the preceding claims, characterized in that the first pulse is a slice pulse.

18. Arrangement according to one of the claims 1 to 17, characterized in that the second pulse is a slice pulse.

19. Arrangement according to one of the claims 1 to 18, characterized in that the third pulse is a slice pulse.

20. Arrangement according to claim 1, 18 or 19, characterized in that the remaining of the three pulses are non-selective pulses.

21. Arrangement according to one of the claims 1 to 15, characterized in that one of the pulses is a slice pulse and an additional one of the pulses is a cutout pulse, i.e. a so-called zoom pulse.

22. Arrangement according to one of the claims 1 to 20, characterized in that at least one of the pulses is a resonance line selective pulse.

23. Arrangement according to one of the claims 1 to 16, characterized in that the first pulse is a resonance line selective pulse.

24. Arrangement according to one of the claims 1 to 16, characterized in that the first pulse is a slice pulse.

25. Arrangement according to one of the claims 1 to 16, characterized in that the first pulse is a cutout or zoom pulse.

26. Arrangement according to one of the claims 23, 24 or 25, characterized in that the second pulse is a non-selective, so-called "hard" pulse.

27. Arrangement according to claim 23, 24 or 25, characterized in that the second pulse is a slice pulse.

28. Arrangement according to one of the claims 1 to 26, characterized in that the control arrangement (14) combines with other methods the production and detection of stimulated echo signals.

29. Arrangement according to claim 28, characterized in that control arrangement (14) combines the spin-echo-tomography method with the production and detection of the stimulated echo signals by adding 180 degree pulses.

## Revendications

1. Dispositif d'examen localement sélectif d'un objet par résonance magnétique de moments de spin comportant:
- un dispositif (16, 24) pour produire un champ magnétique constant dans l'objet,
- des dispositifs (18, 20, 22, 28) pour produire une combinaison variable de trois champs magnétiques à gradient sensiblement perpendiculaires entre eux dans l'objet,
- un dispositif (24, 30) pour appliquer à l'objet un train d'impulsions à haute fréquence qui comprend trois impulsions successives qui présentent des angles de basculement différents de mΠ,
- un dispositif pour détecter des signaux correspondant à une résonance magnétique de moments de spin dans l'objet, et
- un dispositif de commande (14) pour les dispositifs indiqués (16, 24; 18, 20, 22, 28; 24, 30), caractérisé en ce que le dispositif de commande (14) pour une commande des dispositifs indiqués (16, 24; 18, 20, 22, 28; 24, 30) est réalisé avec un programme de déroulement, dans lequel:

– l'intervalle ($\tau$) entre la première et la seconde impulsion est supérieur à $T_{2eff}$ et inférieur à $5T_2$,

–– l'intervalle ($T-\tau$) entre la seconde et la troisième impulsion est supérieur à $T_{2eff}$ et inférieur à $5T_2$,

m étant un nombre entier,

$T_1$ étant le temps de relaxation spin-reseau,

– $T_2$ étant le temps de relaxation spin-spin, et

– $T_{2eff}$ étant le temps de relaxation spin-spin effectif du spin à déterminer dans l'objet,

– l'un au moins des champs à gradient est commuté entre la première et/ou seconde impulsion et/ou la seconde et troisième impulsion et/ou après la troisième impulsion,

– l'une au moins des impulsions est une impulsion sélective en fréquence, et

– au moins un signal d'écho stimulé par la troisième impulsion est détecté.

2. Dispositif selon la revendication 1, caractérisé en ce que $\tau$ est inférieur à $2T_2$.

3. Dispositif selon la revendication 1, caractérisé en ce que ($T-\tau$) est inférieur à $3T_2$.

4. Dispositif selon la revendication 1, caractérisé en ce que l'impulsion sélective en fréquence est formée par un train d'impulsions partielles ou individuelles séparées qui donne la sélectivité en fréquence voulue.

5. Dispositif selon la revendication 4, caractérisé en ce que deux au moins des impulsions individuelles comprennent des fréquences porteuses différentes.

6. Dispositif selon la revendication 4, caractérisé en ce que les impulsions individuelles comprennent des fréquences porteuses identiques.

7. Dispositif selon la revendication 6, caractérisé en ce que les impulsions individuelles sont des impulsions non-sélectives dites "dures", c'est-à-dire ont une enveloppe sensiblement rectangulaire, une durée aussi courte que possible et une amplitude aussi élevée que possible, et ne sont pas sélectives en soi.

8. Dispositif selon la revendication 7, caractérisé en ce que l'impulsion sélective en fréquence existant (au moins à un exemplaire) est une impulsion modulée en fréquence.

9. Dispositif selon l'une des revendications 1 à 8, caractérisé en ce que la première impulsion est une impulsion à 90 degrés (+/–10%).

10. Dispositif selon l'une des revendications 1 à 9, caractérisé en ce que la seconde impulsion est une impulsion à 90 degrés (+/–50%).

11. Dispositif selon l'une des revendications 1 à 10, caractérisé en ce que la troisième impulsion est une impulsion à 90 degrés (+/–50%).

12. Dispositif selon l'une des revendications précédentes, caractérisé en ce qu'au moins la première impulsion et la seconde impulsion sont des impulsions sensiblement à 90 degrés.

13. Dispositif selon l'une des revendications précédentes, caractérisé en ce que la troisième impulsion est une impulsion correspondant à une fraction de l'angle de basculement indiqué, en ce que la troisième impulsion est suivie par au moins une autre "impulsion fractionnaire" à un intervalle supérieur à l'intervalle entre la première impulsion et la seconde impulsion, et en ce que chaque écho stimulé qui suit après l'une des autres impulsions est détecté.

14. Dispositif selon la revendication 13, caractérisé en ce que l'angle de basculement de chaque impulsion fractionnaire est inférieur à 15 degrés, de préférence inférieur à 10 degrés ou inférieur à 5 degrés.

15. Dispositif selon la revendication 13 ou 14, caractérisé en ce que la distance de chaque impulsion fractionnaire à l'impulsion précédente est supérieure à $2\tau$.

16. Dispositif selon la revendication 13, 14 ou 15, caractérisé en ce que l'angle de basculement de chaque autre impulsion est supérieur à l'angle de basculement de chaque impulsion précédente.

17. Dispositif selon l'une des revendications précédentes, caractérisé en ce que la première impulsion est une impulsion de couche.

18. Dispositif selon l'une des revendications 1 à 17, caractérisé en ce que la seconde impulsion est une impulsion de couche.

19. Dispositif selon l'une des revendications 1 à 18, caractérisé en ce que la troisième est une impulsion de couche.

20. Dispositif selon la revendication 17, 18 ou 19, caractérisé en ce que les impulsions restantes parmi les trois impulsions sont des impulsions non-sélectives.

21. Dispositif selon l'une des revendications 1 à 15, caractérisé en ce que l'une des impulsions est une impulsion de couche et en ce qu'une autre des impulsions de coupe, c'est-à-dire une impulsion dite de zoom.

22. Dispositif selon l'une des revendications 1 à 20, caractérisé en ce que l'une au moins des impulsions est une impulsion sélective en ce qui concerne les lignes de résonance.

23. Dispositif selon l'une des revendications 1 à 16, caractérisé en ce que la première impulsion est une impulsion sélective en ce qui concerne les lignes de résonance.

24. Dispositif selon l'une des revendications 1 à 16, caractérisé en ce que la première impulsion est une impulsion de couche.

25. Dispositif selon l'une des revendications 1 à 16, caractérisé en ce que la première impulsion est une impulsion de coupe ou de zoom.

26. Dispositif selon l'une des revendications 23, 24 ou 25, caractérisé en ce que la seconde impulsion est une impulsion non-sélective dite "dure".

27. Dispositif selon la revendication 23, 24 ou 25, caractérisé en ce que la seconde impulsion est une impulsion de couche.

28. Dispositif selon l'une des revendications 1 à 26, caractérisé en ce que le dispositif de commande (14) combine la production et la détection de signaux d'écho stimulés avec d'autres procédés.

29. Dispositif selon la revendication 28, caractérisé en ce que le dispositif de commande (14) combine la production et la détection des signaux d'écho stimulés avec des procédés de tomographie à échos à résonance magnétique de moments de spin par adjonction d'impulsions à 180 degrés.

FIG. 1

FIG. 2

FIG. 3

FIG. 4

FIG. 5

FIG. 6

FIG. 7

FIG. 8

FIG. 9

FIG. 10

FIG. 11

FIG. 12

EP 0 184 840 B1

FIG. 13

FIG. 14

FIG. 15

FIG. 16

FIG. 17

FIG. 18

FIG. 19

FIG. 20

FIG. 21

FIG. 22

FIG. 23

FIG. 24

FIG. 25

FIG. 26

FIG. 27

FIG. 28

EP 0 184 840 B1

FIG. 29

FIG. 30

FIG. 31

FIG. 32

90°. ZOOM    90°. SLICE    90°

RF

Signal
                                    SE          STE

G-Slice

G-Phase

G-Read

FIG. 33

90°. SLICE    90°         90°. ZOOM

RF

Signal
                          SE              STE

G-Slice

G-Phase

G-Read

FIG. 34

FIG. 35

FIG. 36

FIG. 37

FIG. 38

FIG. 39

FIG. 40

FIG. 41

FIG. 42

FIG. 43

FIG. 44

FIG. 45

FIG. 46

FIG. 47

FIG. 48

FIG. 49

FIG. 50

FIG. 51

FIG. 52

FIG. 53

FIG. 54

RF  90°, SLICE  90° STRIPE  $\alpha_n$

Signal

n STE

G-Slice

G-Phase

G-Read

n mal

FIG. 55

RF  90° SLICE  90°, STRIPE  90°

Signal

G-Slice
Flow  SE  STE

G-Phase

G-Read

FIG. 56

EP 0 184 840 B1

FIG. 57

FIG. 58

FIG. 59

FIG. 60

FIG. 61

FIG. 62

FIG. 63

FIG. 64

FIG. 65

FIG. 66

FIG. 67

FIG. 68

FIG. 69

FIG. 70

FIG. 71

FIG. 72